# EUROPEAN PATENT APPLICATION

(11) **EP 3 021 266 A1**
(43) Date of publication of application: **18.05.2016**
(21) Application number: 15194441.0
(22) Date of filing: 13.11.2015
(51) Int. Cl.: G06Q 10/00

(54) **LEAN PRODUCT MODELING SYSTEMS AND METHODS**

(30) Priority: 14.11.2014 US 201414541633
(71) Applicant: The Boeing Company, Chicago, IL 60606-1596 (US)
(72) Inventor: BEAVIN, William Charles, Chicago, IL Illinois 60606-2016 (US); SCHULTE, Mark David, Chicago, IL Illinois 60606-2016 (US); CROW, Michael E., Chicago, IL Illinois 60606-2016 (US)
(74) Representative: Smith, Jeremy Robert

(57) **Abstract**

A lean product modeling system (LPM system). The LPM system includes a plurality of modeling objects representing multiple perspectives of the product, a plurality of corresponding modeling object properties identifying characteristics of those product modeling objects which are used to configure product simulations, and a plurality of corresponding modeling object property data items that define those characteristics and are reflected in product simulations and analyses. All product modeling objects may be linked in an integrated product knowledge model that reflects ontological characteristics of the product or the application as a service and a corresponding operational environment. The integrated product knowledge model defines an authoritative source for any specific corresponding modeling object within the plurality of corresponding modeling objects. The LPM system further includes a device for use in manufacturing the product or implementing the application as the service based on a product design created by the LPM system.

## Description

### BACKGROUND INFORMATION

### 1. Field:

The present disclosure relates generally to devices and methods for the conception, design, build, and integration of products and applications as services.

### 2. Background:

The process of conceiving, designing, modeling, building, and integrating a new product, or an application as a service, may be time and cost intensive, even if performed flawlessly. For example, designing a new commercial jet aircraft may be extremely time intensive and expensive, involving the coordination of potentially thousands of experts.

However, inconsistencies may occur at various stages of developing and integrating a new product or application as a service. If such inconsistencies are discovered late in the development process, they may force the experts working on the product or application to go as far back as to the design stage to correct the inconsistencies. This problem potentially may create very large increases in the time and expense of final deployment or integration of the product or application. Therefore, devices and methods are highly desirable for decreasing the time and money costs of detecting or preventing inconsistencies during development of a product or an application.

### SUMMARY

The illustrative embodiments provide for a system for manufacturing a product or providing an application as a service. The system includes a lean product or service modeling analysis and simulation system. The lean product or service modeling analysis and simulation system includes a non-transitory computer readable storage medium storing a plurality of modeling objects representing multiple perspectives of the product, a plurality of corresponding modeling object properties identifying characteristics of those product modeling objects which are used to configure product simulations, and a plurality of corresponding modeling object property data items that define those characteristics and are reflected in product simulations and analyses. At least some of the modeling objects, the corresponding modeling object properties, and the plurality of corresponding modeling property data items are tailored for each lifecycle phase of the product. At least some of the product knowledge modeling objects are linked in an integrated product knowledge model that reflects ontological characteristics of the product or the application as a service and a corresponding operational environment. The product knowledge model defines an authoritative source for any specific corresponding modeling object within the plurality of corresponding modeling objects. The lean product or service modeling analysis and simulation system further includes at least one processor configured to execute a plurality of disparate tools for manipulating the plurality of modeling objects, each of the plurality of disparate tools comprising at least one corresponding element stored in the non-transitory computer readable storage medium. At least some corresponding elements of the plurality of disparate tools are linked to at least one corresponding concept in the integrated product knowledge model. At least some given corresponding elements of a given tool are linked to a related element in a different tool through an integrated product knowledge model. The lean product or service modeling analysis and simulation system further includes at least one device for use in manufacturing the product or implementing the application as the service based on a product design created by the lean product modeling system.

The illustrative embodiments also provide for a method for manufacturing a product or implementing an application as a service, using a lean product modeling analysis and simulation system. The method includes providing input to at least one non-transitory computer readable storage medium via manipulating at least one physical input device. The input includes a plurality of modeling objects having a plurality of corresponding modeling object properties and a plurality of corresponding object property data items. The plurality of modeling objects representing multiple perspectives of the product or the application as the service. The plurality of corresponding modeling object properties identifies characteristics of those product modeling objects which are used to configure product simulations. At least some of the plurality of modeling objects, the plurality of corresponding modeling object properties, and the plurality of corresponding object property data items are tailored for each lifecycle phase of the product or the application as the service. The lean product modeling analysis and simulation system used in the method also includes an integrated product knowledge model that ontologically defines the product or the application as the service, wherein at least some product knowledge modeling objects are linked to an integrated product knowledge model. The integrated product knowledge model identifies a corresponding authoritative source for corresponding modeling objects of the plurality of modeling objects. The method also includes manufacturing the product or implementing the application as the service using at least one device based on a product design produced by the lean product modeling analysis and simulation system.

The illustrative embodiments also provide for a system. The system includes a lean product modeling analysis and simulation system. The lean product modeling analysis and simulation system includes at least one non-transitory computer readable storage medium storing a plurality of modeling objects having a plurality of corresponding modeling object properties and a plurality of corresponding object property data items. The plurality of modeling objects represents multiple perspectives of a product or an application as a service. The plurality of corresponding modeling object properties identifies characteristics of those product modeling objects which are used to configure product simulations. The plurality of corresponding object property data items defines those characteristics and is reflected in product simulations and analyses. At least some of these objects, properties, and data items are tailored for each lifecycle phase of the product. At least some modeling objects are linked to an integrated product knowledge model that ontologically defines the product or the application as the service and identifies a corresponding authoritative source for corresponding modeling objects of the plurality of modeling objects. The system also includes at least one processor configured to execute a plurality of disparate tools for manipulating the plurality of modeling objects. At least some of the plurality of disparate tools includes at least one corresponding element stored in the non-transitory computer readable storage medium. At least some corresponding elements of the plurality of disparate tools are linked to at least one corresponding concept in the integrated product knowledge model. At least one given corresponding element of a given tool is linked to a related element in a different tool through the integrated product knowledge model. The system also includes at least one input system configured to receive input to create a design of the product or the application as the service using the lean product modeling analysis and simulation system. The system also includes at least one communication system configured to communicate at least one command to at least one device to participate in manufacturing the product, or implementing the application as the service, using the design.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** illustrates a prior art process of the design and manufacture of a product or an application as a service, in accordance with an illustrative embodiment;
**Figure 2** illustrates a process of the design and manufacture of a product or an application as a service using a lean product modeling system, in accordance with an illustrative embodiment;
**Figure 3** illustrates lean product modeling as implemented in an LPM operational context, in accordance with an illustrative embodiment;
**Figure 4** illustrates lean product modeling as implemented in an LPM operational context, plus an overview of an instantiation of the operational concept shown in **Figure** 3, in accordance with an illustrative embodiment;
**Figure 5A****,** **Figure 5B****,** and **Figure 5C****,** together illustrate an example of a product knowledge object model, in accordance with an illustrative embodiment;
**Figure 6** illustrates an example of a multi-discipline lean product model, in accordance with an illustrative embodiment;
**Figure 7** illustrates a multi-discipline lean product simulation example, in accordance with an illustrative embodiment;
**Figure 8A** and **Figure 8B****,** together which illustrate an overview of lean product knowledge testing, in accordance with an illustrative embodiment;
**Figure 9** illustrates an example of a lean product knowledge model extended for regulation, in accordance with an illustrative embodiment;
**Figure 10** illustrates an example of a lean product knowledge model extended for viability, in accordance with an illustrative embodiment;
**Figure 11** illustrates an example of a degree of reduction in cost to conceive, plan, and manufacture a product or an application as a service using lean product modeling as described herein, relative to existing approaches, in accordance with an illustrative embodiment;
**Figure 12** illustrates another example of an implementation of a lean product modeling system, in accordance with an illustrative embodiment;
**Figure 13** illustrates an example of a single tool controlling a source for a concept in the context of lean product modeling, in accordance with an illustrative embodiment;
**Figure 14** illustrates a system for manufacturing a product or providing an application as a service, in accordance with an illustrative embodiment;
**Figure 15** illustrates a method for manufacturing a product or implementing an application as a service, using a lean product modeling analysis and simulation system, in accordance with an illustrative embodiment;
**Figure 16** illustrates a system for using lean product modeling, in accordance with an illustrative embodiment; and
**Figure 17** illustrates a data processing system, in accordance with an illustrative embodiment.

### DETAILED DESCRIPTION

The illustrative embodiments provide several useful functions. For example, the illustrative embodiments recognize and take into account that the process of developing a product or an application as a service may be expensive in terms of time, resources, and money. The illustrative embodiments recognize and take into account that traditional models for the development of products and applications may be prone to inconsistencies.

The illustrative embodiments recognize and take into account that, historically, inconsistencies in isolated engineering design models had to be propagated into testable systems in order to detect them. Additionally, individual system tests might only confirm that the testable systems matched the design model. As a result, historically, it wasn't until integrated system testing could be conducted that many of the design inconsistencies that were initially introduced in the design models could be identified and addressed. The impact of delayed defect identification and resolution can result in exponential cost overruns in the later stages of a major development program.

The illustrative embodiments address these issues by providing lean product modeling (LPM) systems and methods. LPM systems and methods may link modeling objects on a development program to an integrated product knowledge model. Some, possibly all, modeling objects may be so linked. The integrated product knowledge model could be a single knowledge model or a group of knowledge models. In this manner, unnecessary modeling objects are not created or maintained, and modeling objects on a program are discoverable and actionable via product knowledge model queries and hyperlinks. LPM includes modeling objects for simulation, analysis, testing, operations, and support phases of product or application development, all of which are also linked to an integrated product knowledge model. LPM may adapt over the lifecycle of a development program, with traceability from the knowledge model for any lifecycle phase back to the previous lifecycle phase, including operation, support, derivative, and disposal phases of the development program. The LPM approach presents a collaborative environment for model based engineering (MBE).

As indicated above, models can be physical as well as digital. Physical models can be mockups, prototypes, and other physical things. In the case of physical models, the physical models may fit seamlessly into the environments using "internet of things" technology such as where your refrigerator has a webpage and can post the details of what is inside. Similarly, a prototype can have a "webpage" that posts configuration details and measures.

In terms of technical effect, or effecting an improvement in other technologies, LPM directly and concretely increases the speed of the development and manufacture of both physical products and real-world application services by avoiding inconsistencies and providing a collaborative platform for potentially a host of engineers and other subject matter experts. In addition, LPM directly and concretely decreases the cost of the development and manufacture of both physical products and real-world application services. Yet further, LPM may increase the speed at which computers operate or execute software tools that are part of the development program by providing an integrated knowledge model and avoiding inconsistencies during product development.

For example, an LPM (again, lean product model) may be a central organizing knowledge base for an entire engineering effort. Because such a product knowledge model may be based on an ontology specifically created for a product, the speed of a computer may be increased when executing software tools that use the product knowledge model. An example of this speed up is from the use of hyperlinks to point to potentially very large and widely distributed datasets which can be queried remotely via the hyperlink rather than transmitting large volumes of data for local analysis. This use of hyperlinks as pointers is similar to how software code uses software pointers to a location in memory where data is stored, which can be changed significantly faster than copying the data to a prescribed memory location. Additionally, by the same manner, inconsistencies are more likely to be avoided, thereby increasing the speed of manufacturing a physical product while simultaneously decreasing the cost of developing and manufacturing the physical product.

Also, since the underlying ontology is based on reality, the LPM may link to objects in static models, dynamic virtual simulations, or even live physical objects through Internet-of-Things linkages, providing an environment for seamless and continuous testing, diagnostics, and analysis throughout the lifespan of a product, including the product's manufacturing, operational, and support systems. The LPM can also identify inconsistencies in operational systems, such as inconsistencies due to system degradation or failure, or improper system settings, by comparing the operational system knowledge with the intended product knowledge.

The illustrative embodiments contemplate other advantages. Thus, the overview described above does not necessarily limit the claimed inventions.

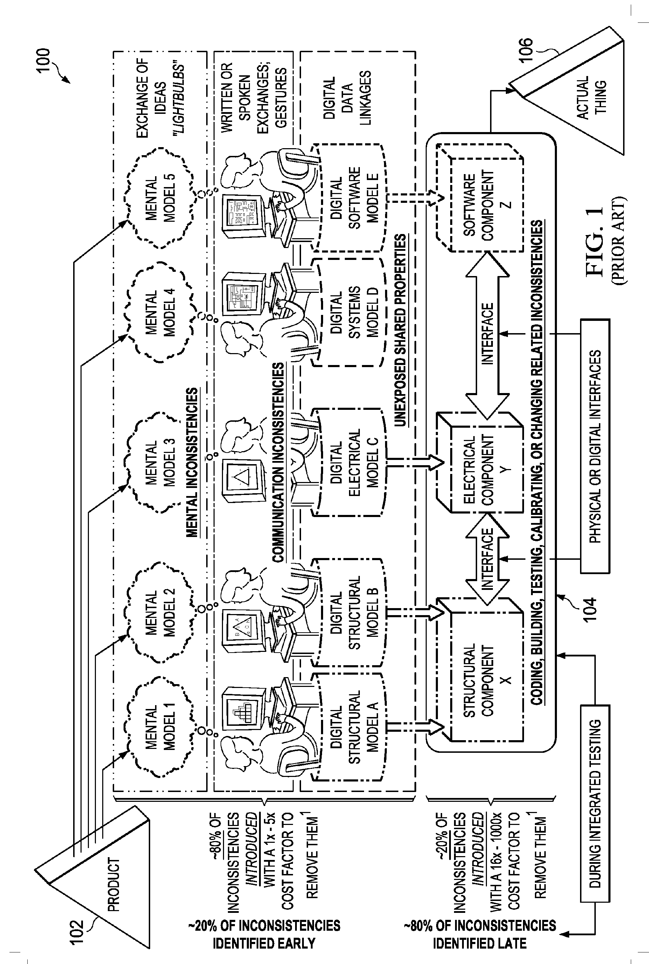

**Figure 1** illustrates a prior art process of the design and manufacture of a product or an application as a service, in accordance with an illustrative embodiment. Process **100** may be implemented as a purely computer process, or may involve the use of computers, which may be widely distributed, as well as physical prototype product systems or components or full scale physical products, which may also be widely distributed.

Process **100** of developing a physical product, or an application as a service, or other development project, may begin by conceiving and then modeling product **102.** Product **102** relates solely to one of the following: physical products, a tangible process that achieves a tangible result, or to computer implemented software (or a non-transitory computer readable storage medium) that relates to a technical effect being a tangible machine or a physical transformation. Conceiving and modeling product **102** may include multiple users, possibly working with multiple tools on multiple computers in potentially multiple locations. This process may include an exchange of ideas and mental models, and may include the use of digital or physical models

When designing product **102,** a variety of inconsistencies may arise during this process of conception and modeling. Inconsistencies in the conception of the product may arise. Communication inconsistencies may arise. Additionally, unexposed shared properties of different aspects of a model may arise during the development process. Other inconsistencies may be present.

During the conception and modeling of product **102,** historically speaking, about twenty percent of these inconsistencies are identified during this early phase of product development. Thus, usually as determined upon retrospect after production and integration of product **102,** about eighty percent of inconsistencies are introduced at this early stage. Had they been identified early, removing such early inconsistencies would have a lower time and money cost factor relative to removing the inconsistencies later in the development process. The time and cost difference may be several orders of magnitude, in some cases, and thus identifying inconsistencies early is considered highly desirable.

Consider a simple example of building a house. An inconsistency may arise in the blueprints of the house. Removing this inconsistency before construction begins may be inexpensive and easy. Removing this inconsistency after the house is finished, with the carpets and drywall in place, may be extremely expensive and time intensive. However, discovering most of these early inconsistencies has, historically, been quite difficult. In fact, about eighty percent of inconsistencies are identified late.

Yet further, about twenty percent of inconsistencies are introduced at the building or manufacturing stage **104** of actual thing **106.** These inconsistencies compound the costs introduced at the earlier stage.

In many cases, engineering tools, including software tools, are used during this historical development process. Almost all engineering tools produce some form of model, such as a unified modeling language (UML) diagram, an electrical schematic, or a three dimensional computer assisted design (CAD) model. These models collectively provide the design basis which is then developed into testable systems and components.

Unfortunately, as shown in **Figure 1****,** most defects in the design models are not identified until integrated testing of the testable systems is conducted. At that point the expense for any required changes is significantly larger than if it had been identified soon after its introduction into the related model, or avoided entirely.

None of the existing individual solutions for collaborative engineering is capable of achieving the desired effect of avoiding, identifying, and resolving most design defects in engineering models before they are instantiated in testable systems for integrated systems tests. The illustrative embodiments address these and other issues.

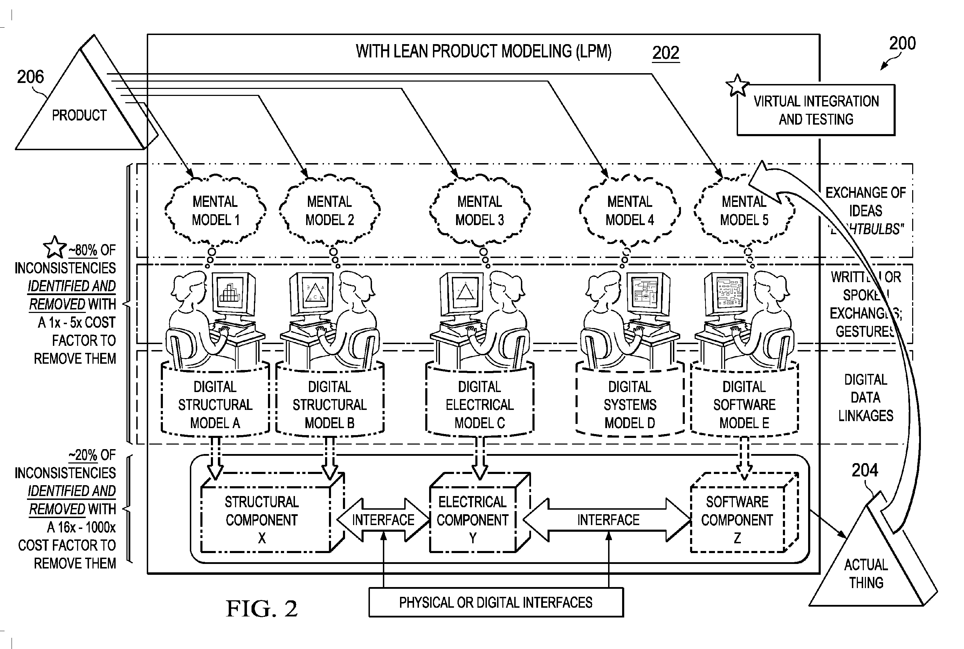

**Figure 2** illustrates a process of the design and manufacture of a product or an application as a service using a lean product modeling system, in accordance with an illustrative embodiment. **Figure 2** represents improvements over the prior art method shown with respect to **Figure 1****.** As used with respect to **Figure 2** and elsewhere here, the acronym "LPM" means "Lean Product Model" or "Lean Product Modeling". However, the term "LPM" also includes the concept of "Lean Service Modeling" or "Lean Product or Service Modeling Analysis and Simulation". LPM systems, methods, and environments may be used with respect to the development of physical products, a tangible process that achieves a tangible result, or to computer implemented software (or a non-transitory computer readable storage medium) that relates to a technical effect being a tangible machine or a physical transformation.

LPM environment **200** helps avoid model inconsistencies and discontinuities, and offers the opportunity for early and continuous integrated product knowledge model testing. In this manner, most defects are avoided entirely or identified quickly after they are introduced. In addition to providing the ability to avoid or quickly identify and resolve design model issues, the LPM approach eliminates the unnecessary effort and expense of producing and maintaining model objects that are not directly traceable to a product. The LPM approach builds directly on as-is engineering capability, requiring no specific modifications to existing engineering function specific environments other than adding the software required to link the models they produce to the integrated product knowledge model. This approach also ensures that specific engineering function specialists have the ability to adapt their environments much faster to ensure each engineering function has technically focused and competitively viable capabilities.

In **Figure 2****,** this LPM environment implementation is indicated generally at reference numeral **202.** LPM environment **200,** in some illustrative embodiments, provides systems and methods that may detect and remove eighty percent of defects earlier in the development process of actual thing **204** from the design or conception of product **206.** The design or conception of product **206** may be, for example, the design or conception of product **106** from **Figure 1****.** The systems and methods that accomplish these goals and effects are described further below.

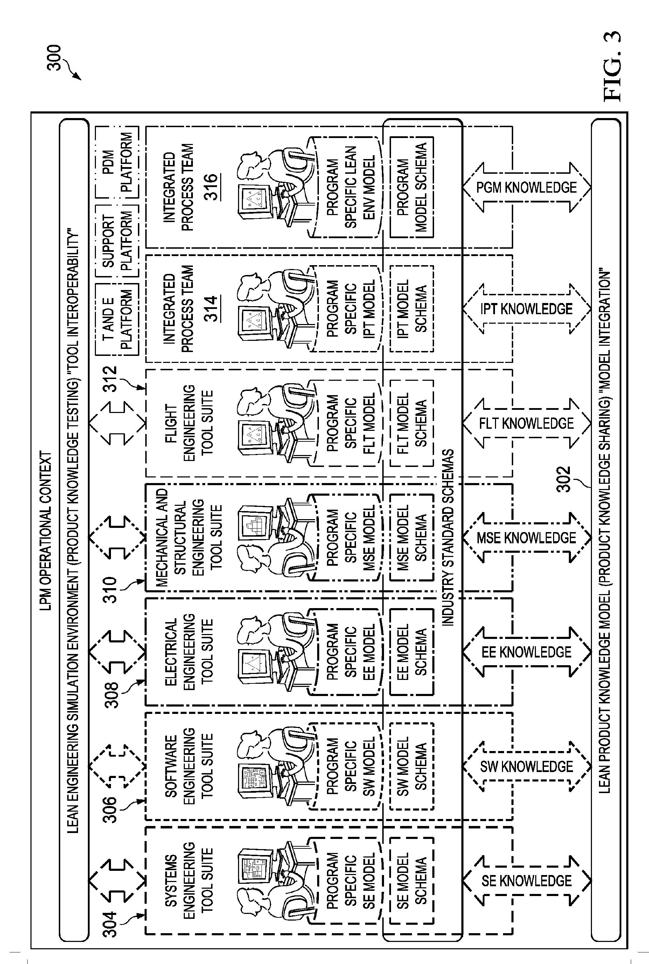

**Figure 3** illustrates lean product modeling as implemented in an LPM operational context, in accordance with an illustrative embodiment. LPM environment **300** provides an example of an implementation of LPM environment **200** of **Figure 2****.** Again, the acronym "LPM" means "Lean Product Model" or "Lean Product Modeling", but contemplates "Lean Service Model" or "Lean Product or Service Modeling Analysis and Simulation." As used herein the term "project" refers, in whole or in part, to development of any tangible product, application as a service, software, or other project, so long as such product is at least one of a physical product, a tangible process that achieves a tangible result, or to computer implemented software (or a non-transitory computer readable storage medium) that relates to a technical effect being a tangible machine or a physical transformation.

LPM environment **300** provides an overview of the LPM approach as implemented in an LPM environment. A significant feature of LPM environment **300** is that all individuals, and collectively groups, working on a particular project may all interact with a lean product knowledge model **302.** Lean product knowledge model **302** ontologically defines all aspects of the project. All tools used by all individuals may ultimately interact with lean product knowledge model **302,** whether directly or indirectly. Thus, for example, different suites of tools, such as suite **304,** suite **306,** suite **308,** suite **310,** and suite **312,** may all use industry standard schemas and all interact with lean product knowledge model **302,** even if any of these suites are incompatible with each other.

Thus, a significant operational aspect of LPM environment **300** is that directly supporting the preferred engineering tool suites of highly specialized engineering disciplines is at the heart of the approach. Optionally, each engineering discipline may also choose to use the LPM approach within their specialized suite of tools, depending on the nature of the tools and the lifecycle phase being addressed. If they choose to use the approach for the full lifecycle or just certain portions of it, the implementation would essentially be a "recursive" instantiation of the LPM approach within the specific environment for that engineering discipline.

Also indicated in **Figure 3** are program specific Integrated Process Teams (IPTs), including integrated process team **314** and integrated process team **316.** These integrated process teams may be composed of various components from any required or desired engineering disciplines, as well as an overarching program level tool suite that is similarly composed. These tools may generate knowledge from the perspective of the specialist using one or more of these tools. These tools may also consume knowledge generated from the perspectives of others.

Rather than trying to translate the languages or syntax between each combination of specialist and tool in a point-to-point approach, the LPM approach links the knowledge of each specialist to elements of shared lean product knowledge model **302.** The LPM approach also links the knowledge consumed by a specialist to other elements of the shared product knowledge model, which are generated by other specialists. This approach connects the knowledge generated and consumed by all participants in a project and produces lean product knowledge model **302** with queriable and traceable links to all of the elements of the model.

A benefit to this approach is the elimination of the need to search for knowledge, such as how some users may search via an Internet search engine, because knowledge elements are already connected by hyperlinks within integrated product knowledge model **302.** Thus, for example, a user may be presented with hyperlinks that allow the user to delve further into a topic of interest or to allow the user to see broader picture of the particular knowledge element within the overall project. The user may also query the knowledge model using standard knowledge model query protocols such as SPARQL (Simple Protocol RDF (Resource Description Framework) Query Language).

Note in **Figure 3** that each engineering function may leverage industry standard modeling schemas, such as AP233, AP239, and others. This approach has been adopted by initiatives such as modeling and simulation information in a collaborative systems engineering context (MoSSEC). While the bottom portion of **Figure 3** depicts static linkages (hyperlinks) between models, the top portion depicts dynamic interactions and data exchange between executing models, simulations, software, systems, development tools, and analysis tools, which effectively "test" the knowledge models upon which they are based. Collectively, the operational environment provides the ability to capture knowledge, share it, test it, perform analytics on it, and make smart decisions based on it.

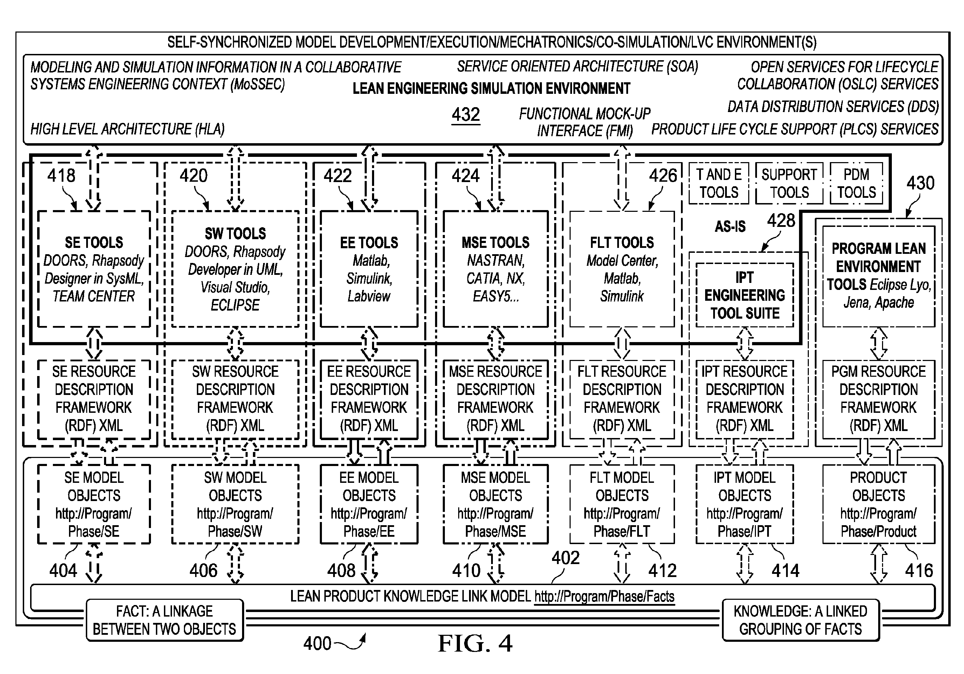

**Figure 4** illustrates lean product modeling as implemented in an LPM operational context, plus an overview of an instantiation of the operational concept shown in **Figure 3****,** in accordance with an illustrative embodiment. Similarly, the LPM implementation shown in **Figure 4** may be an instantiation of the operational concept shown in **Figure 2****.** Thus, for example, LPM environment **400** may be, for example, LPM environment **300** of **Figure 3** or LPM environment **200** of **Figure 2****.** Similarly, lean product knowledge link model **402** may be lean product knowledge model **302** of **Figure 3****.**

As indicated above, **Figure 4** provides an overview of an instantiation of the operational concept shown in **Figure 3****.** The instantiation illustrates how the existing engineering function specific tool suites (enclosed in an "As-Is" container) each produce program, discipline, and tool specific models in various formats. These formats may include flat files, databases, XML documents, and many other formats. These models are either generated directly in a linked data compatible format (with extensions such as .rdf, .owl, and others) or wrapped with middleware that converts them to XML documents in linked data compatible formats. These XML documents then may be persisted as web-accessible hyperlinks, such as link **404,** link **406,** link **408,** link **410,** link **412,** link **414,** and link **416.** Each individual object may be directly accessible via a hyperlink.

The use of industry standard modeling schemas by the engineering functions can facilitate the development and maintenance of these interfaces. These persisted, web-accessible, hyperlinked objects become discoverable by ensuring the environment in which they are hosted complies with related standards such as Open Services for Lifecycle Collaboration (OSLC).

Linkages between the product knowledge model objects and the engineering function specific model objects are shown at corresponding arrows **418, 420, 422, 424, 426, 428,** and **430.** These links are provided by model objects. These links may be referred to as "facts" or "triplestores" which may include two hypertext transport protocol (HTTP) hyperlinks indicating the two objects being linked. A third HTTP hyperlink pointing to an object may define the ordered relationship between two objects. The fact or triplestore itself may also have an HTTP hyperlink, making it "linkable" as well.

These facts can collectively be referred to as "knowledge". Knowledge, when combined with the objects linked to the "facts", can be referred to as a "Knowledge Model".

The "containers" that persist these objects and make them web accessible and hyper-linkable also support query capabilities such as SPARQL. SPARQL is an acronym meaning "Simple Protocol and RDF ('Resource Description Framework') Query Language". SPARQL may make every object in lean product knowledge link model **402** accessible for emerging data analytics and decision support techniques.

Lean Engineering Simulation Environment **432** depicts the environment in which the engineering tools, or things produced by the tools such as software or prototype hardware, such as 3D printed objects, prototypes, simulators, and others, are executed and interact with each other. This environment is referred to as "lean" because every object within it may be traceable, as described above, to at least one object in lean product knowledge link model **402,** including objects intended specifically for simulation.

Simulation specific objects are those that are necessary or desirable to adequately stimulate the product model objects specifically defining the product. Simulation specific objects may also represent simulation truth which, when compared to the perception of simulation truth of the system under test, indicates how effectively the system is performing.

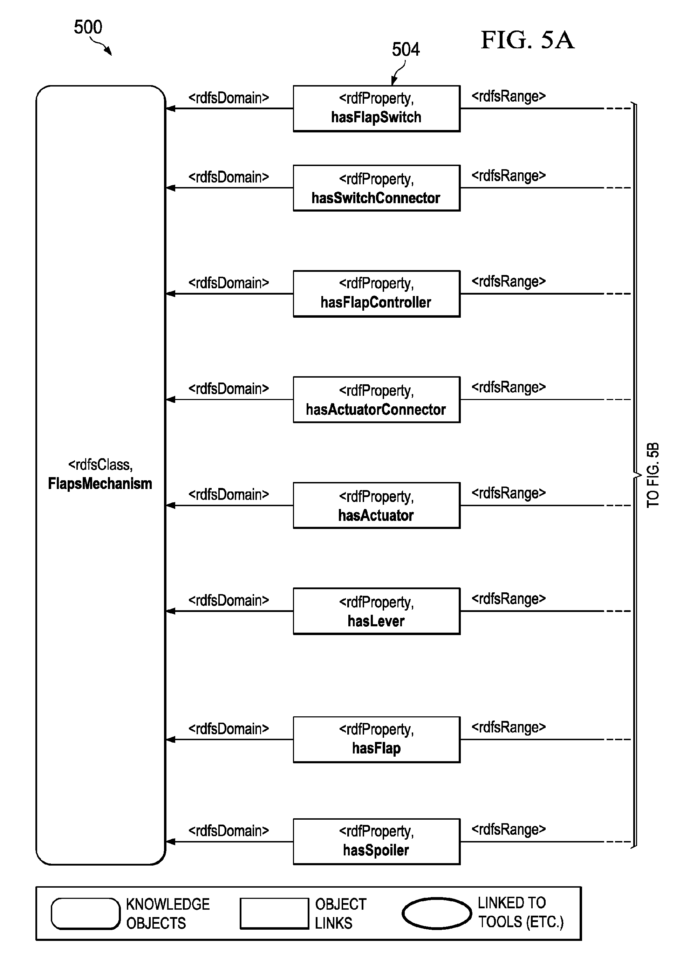

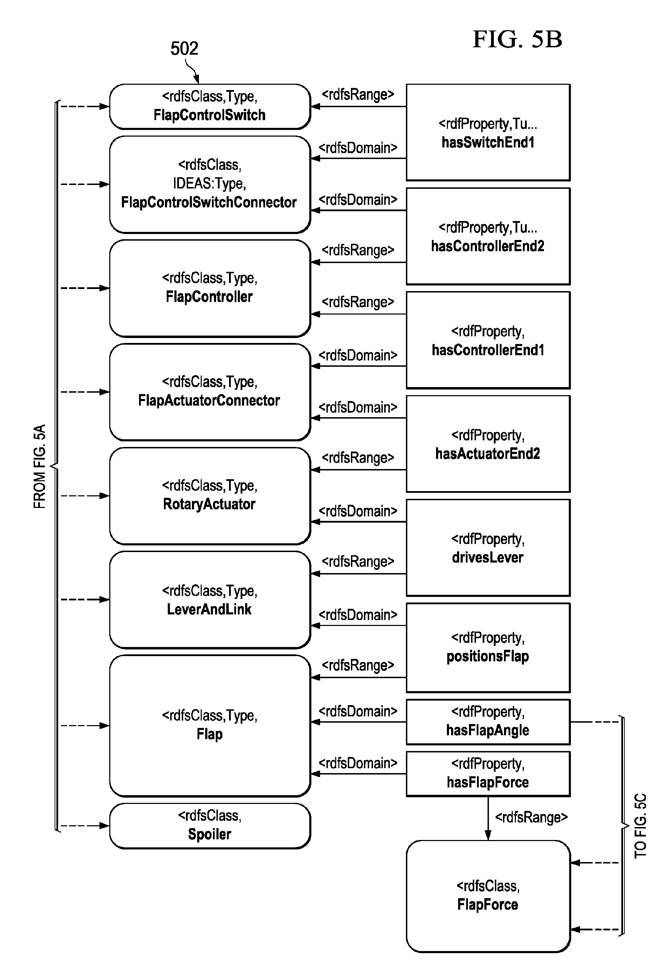

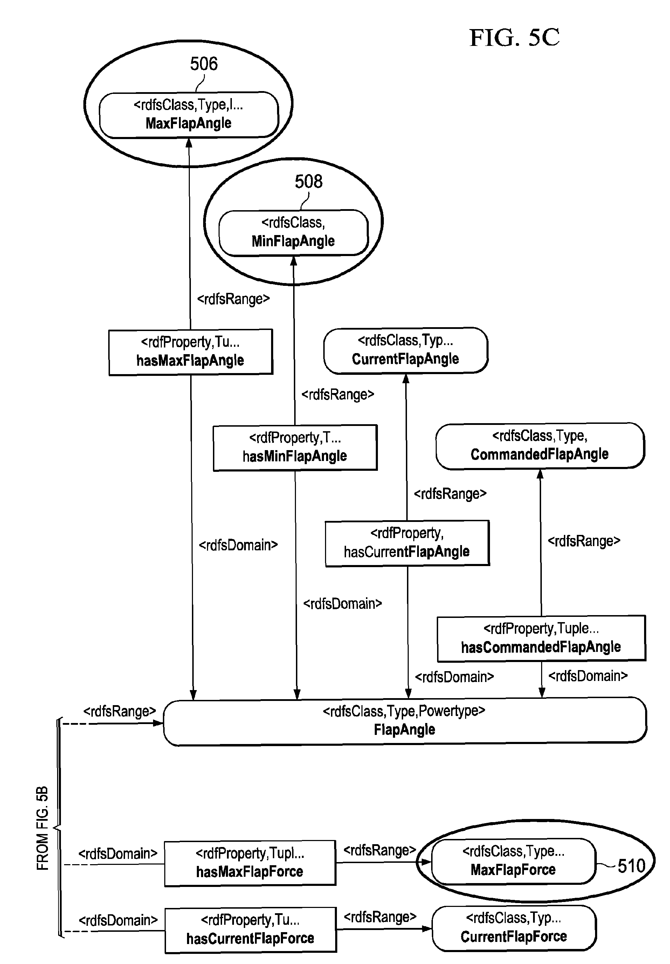

**Figure 5A****,** **Figure 5B****,** and **Figure 5C****,** illustrates an example of a product knowledge object model, in accordance with an illustrative embodiment. Product knowledge object model **500** may be, for example, lean product knowledge link model **402** of **Figure 4** or lean product knowledge model **302** of **Figure 3****.**

In particular, **Figures 5A-5C** shows a diagram of an example of the use of "facts", as described with respect to **Figure 4****,** to model knowledge about "flaps" in what is referred to as a "knowledge network graph" depiction. The objects portrayed as rectangles, such as object **502,** are "shared" knowledge model objects that reside in lean product knowledge link model **402** of **Figure 4****.** Certain of these shared knowledge model objects may be linked to tools, as indicated for example by object **506,** object **508,** and object **510.**

The objects portrayed as ellipses, such as object **504,** along with their associated connectors, are "knowledge link" objects. These knowledge link objects may also reside in lean product knowledge link model **402** of **Figure 4****.**

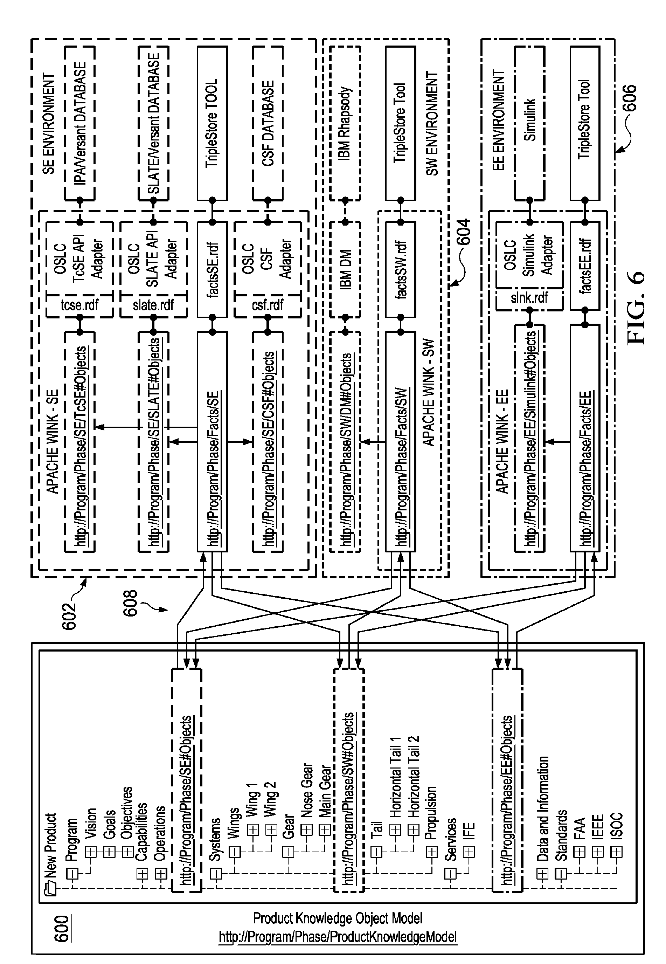

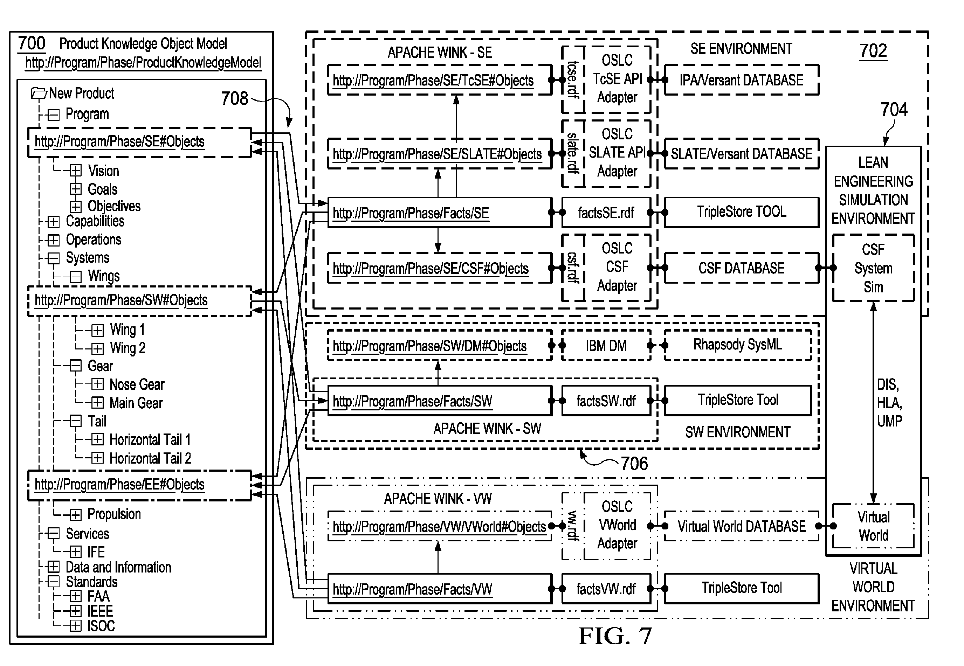

The illustrative embodiments shown in **Figures 5A-5C** do not necessarily limit the claimed inventions, as many different product knowledge models may exist. For example, **Figure 6** and **Figure 7** provide additional examples of implementations of a product knowledge object model.

**Figure 6** illustrates an example of a multi-discipline lean product model, in accordance with an illustrative embodiment. Product knowledge object model **600** is an alternative implementation of a knowledge object model, such as product knowledge object model **500** of **Figures 5A-5C****.** Product knowledge object model **600** may also be lean product knowledge link model **402** of **Figure 4** or lean product knowledge model **302** of **Figure 3****.**

As shown in **Figure 6****,** multiple tool environments, such as tool environment **602,** tool environment **604,** and tool environment **606** may interact with a single model, product knowledge object model **600.** Each of these tool environments may use different tools. Some of these different tools may be incompatible with each other, though because all tools interact with product knowledge object model **600,** conflicts are avoided. In this example, the tool environments define the subjects and predicates in triplestore facts and link to objects in the product knowledge object model **600,** which minimizes the need for additional integration efforts between tool environments. However, other configurations are envisioned as well, such as when the predicates in the triplestore facts reside in the product knowledge object model **600** and link to objects in the tool environments. Other configurations may include interfaces, gateways, data caches, or other forms of middleware defining the linkages between the tool environments and the product knowledge object model **600.**

Additionally, arrows **608** show that each of the different tool environments may interact with multiple objects within product knowledge object model **600.** Arrows **608** also indicate that multiple tools may interact with a single object in product knowledge object model **600.** Conflicts between different tool environments are avoided because each tool environment deals with a single ontology within product knowledge object model **600.** Conflicts within a given object in product knowledge object model **600** are avoided because a single source is used to control a particular object, though that source may change periodically over the lifecycle of a product.

**Figure 7** illustrates a multi-discipline lean product simulation example, in accordance with an illustrative embodiment. Product knowledge object model **700** is an alternative implementation of a knowledge object model, such as product knowledge object model **600** of **Figure 6** or product knowledge object model **500** of **Figures 5A-5C****.** Product knowledge object model **700** may also be lean product knowledge link model **402** of **Figure 4** or lean product knowledge model **302** of **Figure 3****.**

As shown in **Figure 7****,** multiple tool environments, such as tool environment **702,** tool environment **704,** and tool environment **706,** may interact with a single model, product knowledge object model **700.** Each of these tool environments may use different tools. Some of these different tools may be incompatible with each other, though because all tools interact with product knowledge object model **700,** conflicts are avoided.

Additionally, arrows **708** show that each of the different tool environments may interact with multiple objects within product knowledge object model **700.** Arrows **708** also indicate that multiple tools may interact with a single object in product knowledge object model **700.** Conflicts between different tool environments are avoided because each tool environment deals with a single ontology within product knowledge object model **700.** Conflicts within a given object in product knowledge object model **700** are avoided because a single source is used to control a particular object.

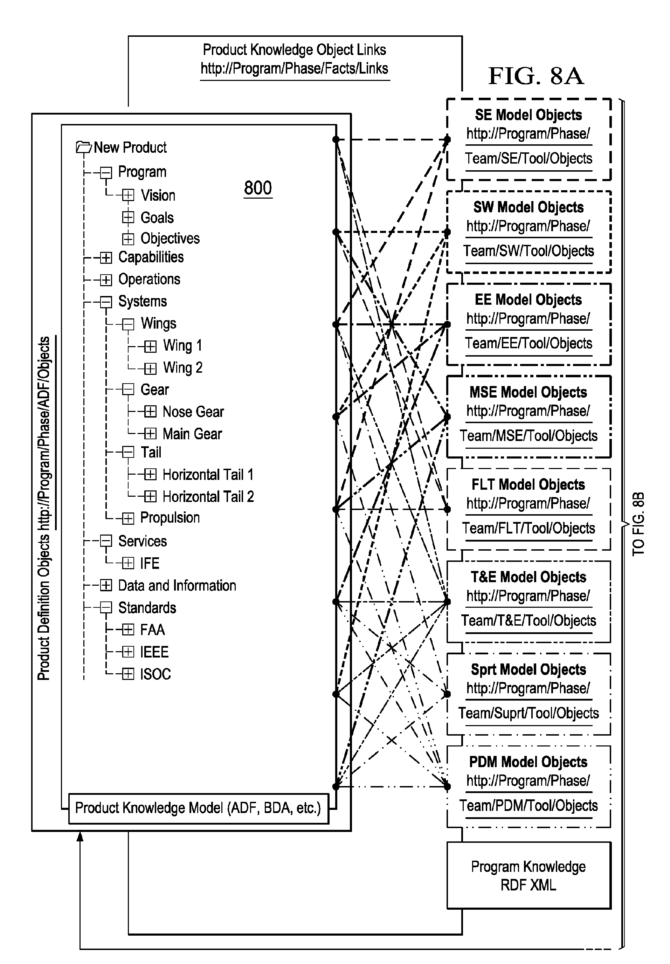

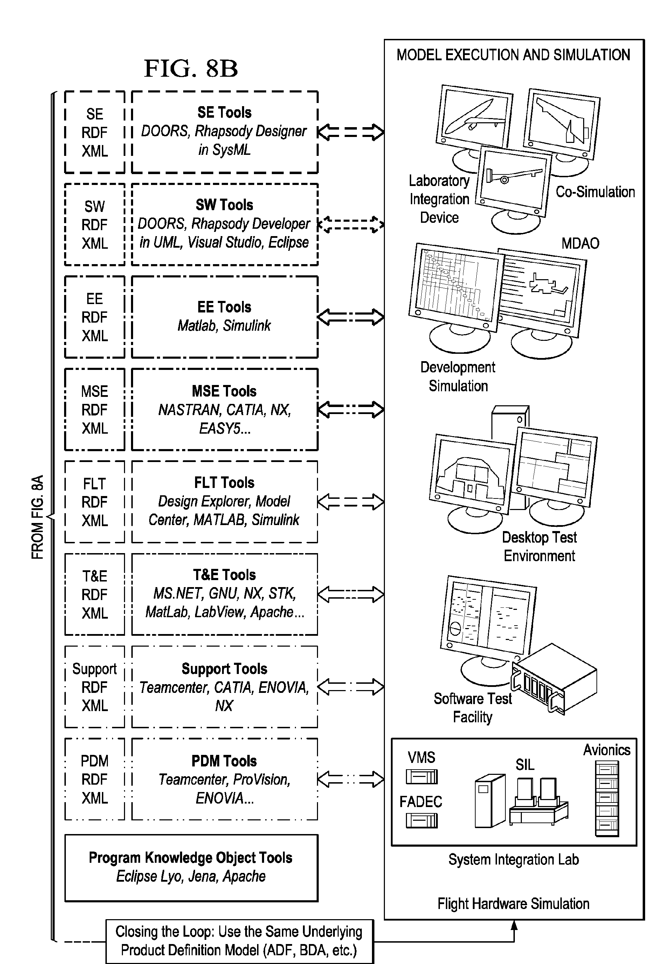

**Figure 8A** and **Figure 8B****,** together illustrate an overview of lean product knowledge testing, in accordance with an illustrative embodiment. Product knowledge object model **800** is an alternative implementation of a knowledge object model, such as product knowledge object model **700** of **Figure 7****,** product knowledge object model **600** of **Figure 6** or product knowledge object model **500** of **Figure 5A-****5C.** Product knowledge object model **800** may also be lean product knowledge link model **402** of **Figure 4** or lean product knowledge model **302** of **Figure 3****.** **Figures 8A** **and** **8B** provides an overall view of how simulation and analysis are used throughout a products lifecycle to continually test product knowledge object model **800,** which again is an integrated accumulation of all facts and which underlies all tools used in the environment.

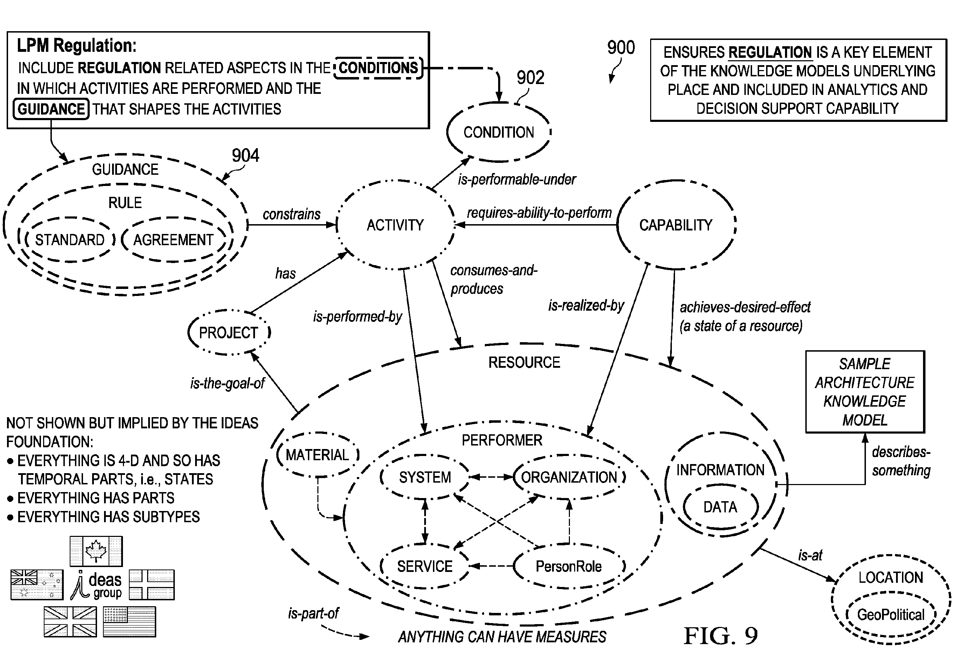

**Figure 9** illustrates an example of a lean product knowledge object model extended for regulation, in accordance with an illustrative embodiment. Product knowledge object model **900** is an alternative implementation of a knowledge object model, such as product knowledge object model **800** of **Figures 8A-8B****,** product knowledge object model **700** of **Figure 7****,** product knowledge object model **600** of **Figure 6** or product knowledge object model **500** of **Figures 5A-5C****.** Product knowledge object model **900** may also be lean product knowledge link model **402** of **Figure 4** or lean product knowledge model **302** of **Figure 3****.**

**Figure 9** shows how the underlying architecture knowledge model can be extended to include even abstract concepts such as "regulation knowledge". Regulation knowledge specifies the regulation conditions under which activities should be performed and guidance for regulations, which shapes the activities based on established regulation practices.

Thus, for example, product knowledge model **900** may include objects such as conditions object **902** and guidance object **904.** In this manner, product knowledge model **900** takes into account regulation related aspects in the conditions in which activates are performed and the guidance that shapes the activities. This architecture ensures that regulation is a key element of the knowledge models underlying LPM and included in analytics and decision support capability. This architecture also supports the reduction of inconsistencies in models by regulating activities as well as the demonstrated skills of the performers performing the activities through linkage between the product knowledge model and the training records and job assignments of the performers.

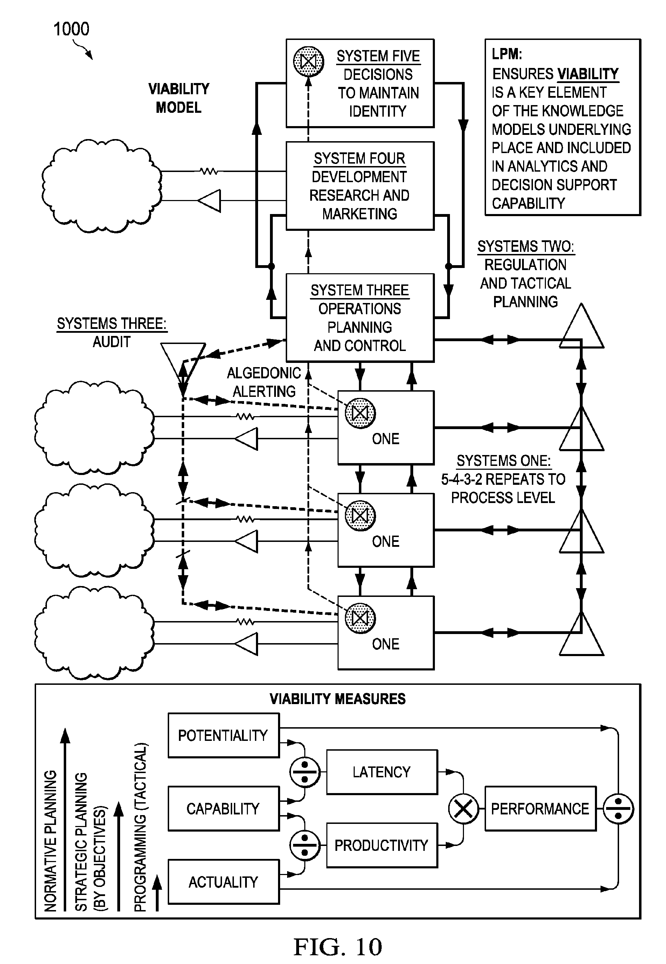

**Figure 10** illustrates an example of a lean product knowledge object model extended for viability, in accordance with an illustrative embodiment. Product knowledge object model **1000** is an alternative implementation of a knowledge object model, such as product knowledge object model **900** of **Figure 9****,** product knowledge object model **800** of **Figures 8A-8B****,** product knowledge object model **700** of **Figure 7****,** product knowledge object model **600** of **Figure 6** or product knowledge object model **500** of **Figures 5A-5C****.** Product knowledge object model **900** may also be lean product knowledge link model **402** of **Figure 4** or lean product knowledge object model **302** of **Figure 3****.**

**Figure 10** shows how the architecture of a knowledge model, product knowledge object model **1000,** can be shaped around the principles of measuring and sustaining viability using the Stafford Beer Viable System Model (VSM) approach. In an era of market uncertainty and organizational dynamics, the use of integrated knowledge models shaped to support both enterprise and solution viability can help ensure sustained success in a continuously changing operational environment.

From an enterprise perspective, linking the underlying architecture knowledge model to established enterprise process models provides a way to identify and assess the applicability and utilization of enterprise processes. In turn, this affect provides continuous opportunities to reduce or eliminate unused processes or update underused processes.

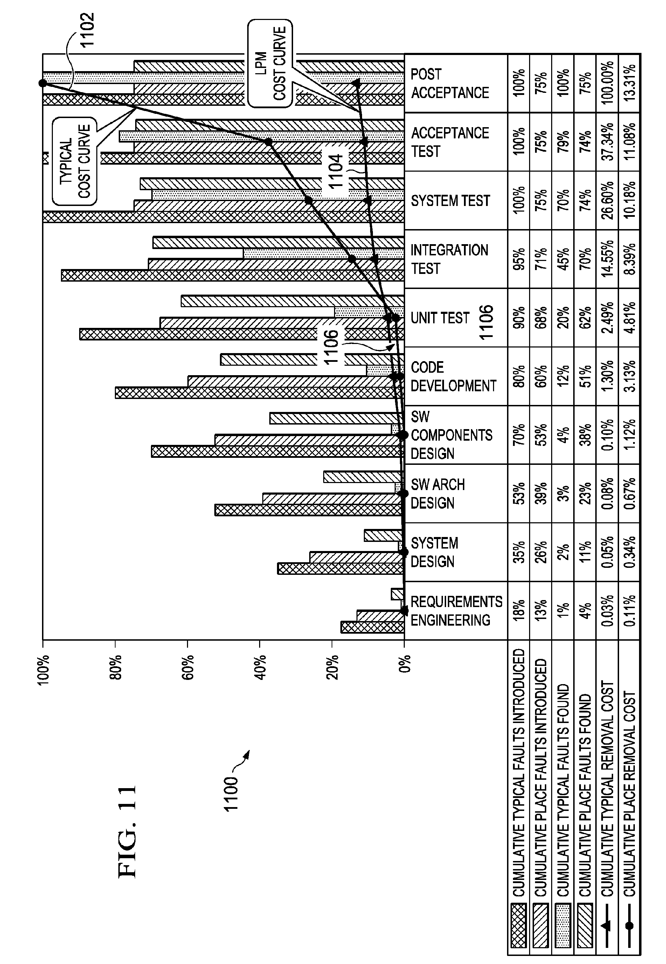

**Figure 11** illustrates an example of a degree of reduction in cost to conceive, plan, and manufacture a product or an application as a service using lean product modeling as described herein, relative to existing approaches, in accordance with an illustrative embodiment. As described above, the existing approach shown in **Figure 1** has produced unsustainably increasing costs for both commercial and military aerospace products. This typical cost curve is shown in graph **1100** at curve **1102.** Cost overruns can become unacceptably high because inconsistencies are discovered late in the product development process. In some cases, multiple products might have to be designed, built, and tested until all inconsistencies are reduced or eliminated, and a desirable product is produced.

However, the lean product modeling approach described with respect to **Figure 2** through **Figure 10** offers a potentially huge reduction in the overall cost curve, as shown at cost curve **1104.** As can be seen generally at area **1106,** costs using the lean product modeling techniques described herein may be slightly higher in the middle of a project, as inconsistencies are caught earlier, the end result is a substantial reduction in overall costs. The amount of reduction in costs due to inconsistencies may be eighty percent or more, given the very high costs imposed by typical cost curve **1102.**

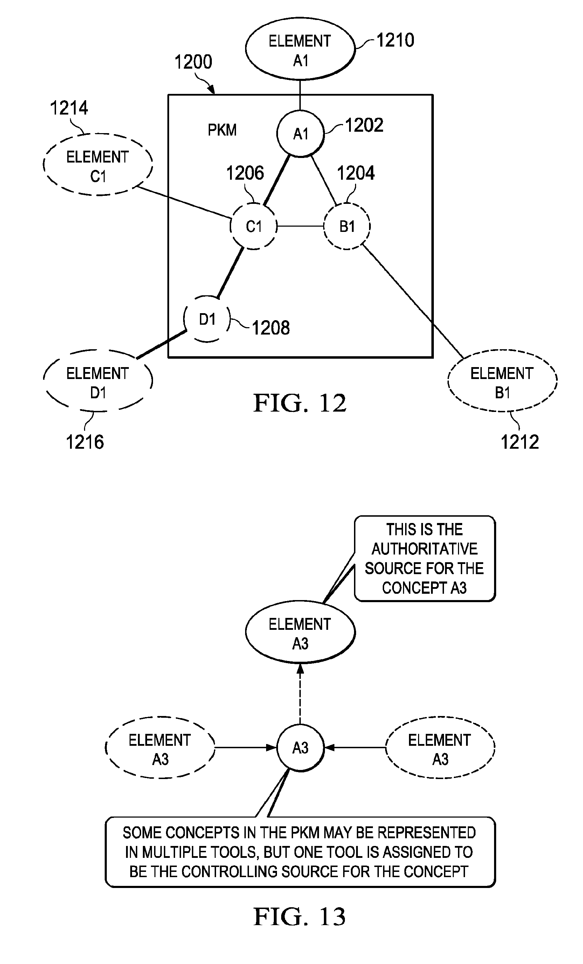

**Figure 12** illustrates another example of an implementation of a lean product modeling system, in accordance with an illustrative embodiment. Product knowledge object model **1200** is an alternative implementation of a knowledge object model, such as product knowledge object model **1000** of **Figure 10****,** product knowledge object model **900** of **Figure 9****,** product knowledge object model **800** of **Figures 8A-****8B,** product knowledge object model **700** of **Figure 7****,** product knowledge object model **600** of **Figure 6** or product knowledge object model **500** of **Figures 5A-5C****.** Product knowledge object model **900** may also be lean product knowledge link model **402** of **Figure 4** or lean product knowledge model **302** of **Figure 3****.**

Product knowledge object model **1200** may include a number of facts, as described above. A fact may also be referred to as a concept. Product knowledge object model **1200** includes concept A1 **1202,** concept B1 **1204,** concept C1 **1206** and concept D1 **1208.** Each concept is connected to an element of a tool used to manipulate facts or concepts within product knowledge object model **1200.** Thus, for example element A1 **1210** refers to a specific element of "Tool A". Likewise, element B1 **1212** refers to a specific element of tool B, element C1 **1214** refers to a specific element of tool C, and element D1 **1216** refers to a specific element of tool D.

As product knowledge object model **1200** is an accumulation of facts or concepts, an ontology may be created for a product being engineered using lean product modeling. Product knowledge object model **1200** then becomes the central organizing knowledge base for the entire engineering effort.

Thus, rather than linking objects in different tools to each other, they are linked to an ontology. The ontology identifies the authoritative source for the definition of each concept. In other words, the ontology identifies which tool is the owner of the concept. In this manner, conflicts may be avoided.

Attention is now turned to an ontological analysis of the models captured in different tools. In an illustrative embodiment, all concepts in the ontology may map to requirements. All terms in the requirements may map to the ontology. Because all concepts are used correctly in the requirements, requirements should not relate concepts that are not related in the ontology. Hence, requirements that are inconsistent with each other should be resolved, requirements that are redundant should be removed, and requirements that are linked to concepts marked as obsolete in the ontology should be removed. Likewise, requirements that are constructed inconsistently with the requirement template and the ontology should be removed.

Similarly, all concepts in the ontology may map to the architecture. All terms in the architecture may map to the ontology.

**Figure 13** illustrates an example of a single tool controlling a source for a concept in the context of lean product modeling, in accordance with an illustrative embodiment. Element A3 **1300** may be an element of Tool A as described with respect to **Figure 12****.** Thus, element A3 **1300** may be part of product knowledge model **1200** of **Figure 12. Figure 13** shows that some concepts in the product knowledge model may be represented in multiple tools, but one tool is assigned to be the controlling, authoritative source for the concept in the product knowledge model.

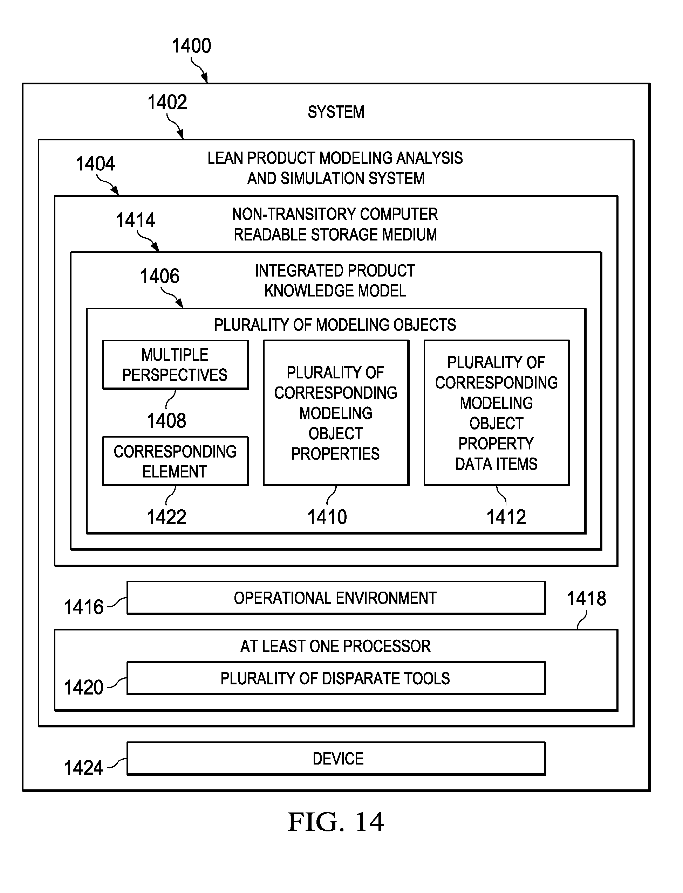

**Figure 14** illustrates a system for manufacturing a product or providing an application as a service, in accordance with an illustrative embodiment. System **1400** may be a system for implementing LPM environment **200** of **Figure 2****,** and may use any of the product knowledge models described with respect to **Figure 2** through **Figure 13****.**

System **1400** may be for manufacturing a product or providing an application as a service. System **1400** may include lean product or service modeling analysis and simulation system **1402.** Lean product or service modeling analysis and simulation system **1402** may include non-transitory computer readable storage medium **1404.** Non-transitory computer readable storage medium **1404** may store plurality of modeling objects **1406.** Plurality of modeling objects **1406** may represent multiple perspectives **1408** of the product, plurality of corresponding modeling object properties **1410** identifying characteristics of those product modeling objects which are used to configure product simulations, and plurality of corresponding modeling object property data items **1412** that define those characteristics and are reflected in product simulations and analyses. The modeling objects **1406,** the corresponding modeling object properties **1410,** and the plurality of corresponding modeling property data items **1412** may be tailored for each lifecycle phase of the product. At least some product modeling objects are linked in a single integrated product knowledge model **1414** that reflects ontological characteristics of the product or the application as a service and corresponding operational environment **1416.** Single integrated product knowledge model **1414** may define an authoritative source for any specific corresponding modeling object within plurality of modeling objects **1406.**

Note that there may be many non-transitory storage mediums, such as but not limited to data servers, which each store a portion of the plurality of modeling objects. For instance, each data server may reflect a different perspective. A systems engineering model may be one perspective stored on a systems engineering design server, electrical schematic models on a different electrical engineering design server may be another perspective, and computer assisted design models on a mechanical/structural model server may be another perspective. The knowledge model links may reside on yet another server with hyperlinks pointing to corresponding objects on any of the servers. Thus, the illustrative embodiments may be varied.

Lean product modeling analysis and simulation system **1402** also includes at least one processor **1418.** At least one processor **1418** may be configured to execute plurality of disparate tools **1420** for manipulating plurality of corresponding modeling object properties **1410.** Each of plurality of disparate tools **1420** may include at least one corresponding element **1422** stored in non-transitory computer readable storage medium **1404.** Corresponding elements of plurality of disparate tools **1420** are linked to at least one corresponding concept in single integrated product knowledge model **1414.** A given corresponding element of a given tool is linked to a related element in a different tool through single integrated product knowledge model **1414.**

System **1400** also includes device **1424.** Device **1424** may be for use in manufacturing the product or implementing the application as the service based on a product design created by lean product modeling analysis and simulation system **1402.**

The illustrative embodiments described with respect to **Figure 14** may be varied. For example, in an illustrative embodiment, at least some of plurality of disparate tools **1420** may be incompatible with each other without use of single integrated product knowledge model **1414.** In another illustrative embodiment, the given tool and the different tool are incompatible with each other.

In an illustrative embodiment, at least one processor **1418** may be configured to perform cross tool engineering data analysis through the integrated product knowledge model. In an illustrative embodiment, plurality of modeling objects **1406** may be discoverable by at least one product knowledge model query that traverses a hyperlink to a modeling object stored on a different non-transitory computer readable storage medium.

In an illustrative embodiment, plurality of modeling objects **1406** may be configured to be traced and analyzed throughout a lifecycle of a program through connections provided and maintained within single integrated product knowledge model **1414.** In a similar illustrative embodiment, the lifecycle phase is selected from the group consisting of exploratory, conceptual, prototyping, developmental, manufacturing, operation, support, derivative product creation, and product disposition.

In an another illustrative embodiment, a change to a given modeling object in plurality of modeling objects **1406** may set a flag to validate every other related modeling object in plurality of modeling objects **1406** linked to the given modeling object via single integrated product knowledge model **1414.** In another illustrative embodiment, single integrated product knowledge model **1414** may further include data describing conditions of use for the product, the data including preconditions and constraints.

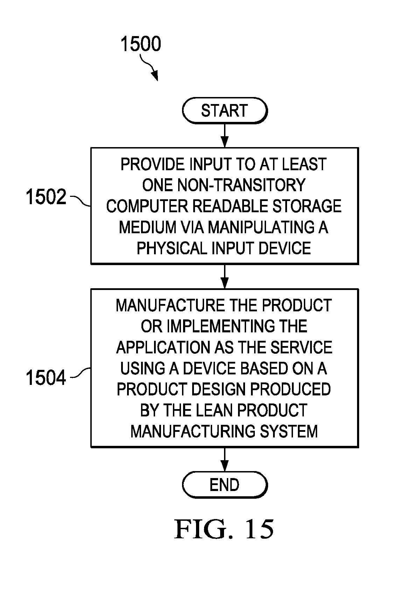

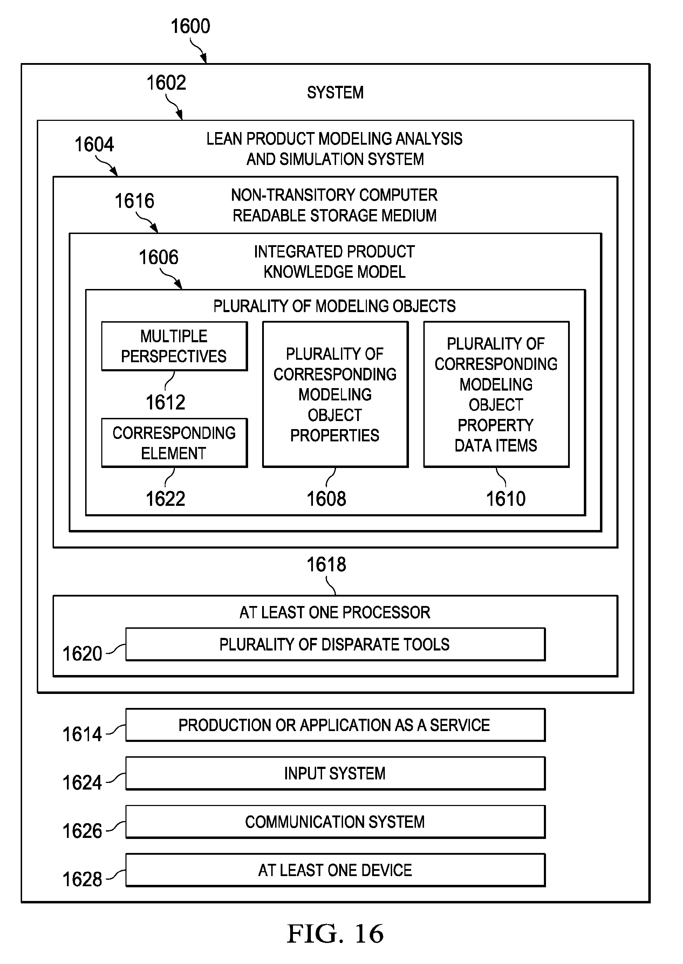

**Figure 15** illustrates a method for manufacturing a product or implementing an application as a service, using a lean product modeling analysis and simulation system, in accordance with an illustrative embodiment. Method **1500** may be implemented using a lean product manufacturing system, such as system **1400** of **Figure 14** or system **1600** of **Figure 16****,** using lean product manufacturing techniques as described with respect to **Figure 2** through **Figure 13****.** Thus, method **1500** may be a method for manufacturing a product or implementing an application as a service using a lean product modeling analysis and simulation system.

Method **1500** may begin by providing input to at least one non-transitory computer readable storage medium via manipulating a physical input device (operation **1502**). The input may include a plurality of modeling objects having a plurality of corresponding modeling object properties and a plurality of corresponding object property data items. The plurality of modeling objects may represent multiple perspectives of the product or the application as the service. The plurality of corresponding modeling object properties may identify characteristics of those product modeling objects which are used to configure product simulations. The plurality of modeling objects, the plurality of corresponding modeling object properties, and the plurality of corresponding object property data items all may be tailored for each lifecycle phase of the product or the application as the service. The input may also include an integrated product knowledge model that ontologically defines the product or the application as the service. Each product modeling object may be linked to the integrated product knowledge model. The integrated product knowledge model may identify a corresponding authoritative source for corresponding modeling objects of the plurality of modeling objects.

Method **1500** may then include manufacturing the product or implementing the application as the service using a device based on a product design produced by the lean product manufacturing system (operation **1504**). The process may terminate thereafter.

Method **1500** may be further varied. For example, a plurality of disparate tools for manipulating the plurality of modeling objects may be stored in the at least one non-transitory computer readable storage medium, each of the plurality of disparate tools comprising at least one corresponding element. In this case, method **1500** may further include linking, using at least one processor in communication with the non-transitory computer readable storage medium, every corresponding element of the plurality of disparate tools to at least one corresponding concept in the integrated product knowledge model.

In another illustrative embodiment, method **1500** may further include linking, using at least one processor, a given corresponding element of a given tool to a related element in a different tool through the integrated product knowledge model. In this case, method **1500** may further include creating, and storing on at least one non-transitory computer readable storage medium, a product design using the plurality of disparate tools. Using the plurality of disparate tools comprises at least one user manipulating at least one physical user input device. In another illustrative embodiment, at least some of the plurality of disparate tools is incompatible with each other without use of the integrated product knowledge model.

In another illustrative embodiment, method **1500** may further include performing, by the at least one processor, cross tool engineering data analysis through the integrated product knowledge model. In another illustrative embodiment, method **1500** may include discovering the plurality of modeling objects by using at least one product knowledge model query that may traverse a hyperlink to a modeling object stored on a different non-transitory computer readable storage medium.

In another illustrative embodiment, method **1500** may include, in response to changes on a given modeling object in the plurality of modeling objects, validating every related modeling object in the plurality of modeling objects that are linked to the given modeling object. Validating may be performed via the single integrated product knowledge model.

**Figure 16** illustrates a system for using lean product modeling, in accordance with an illustrative embodiment. System **1600** may be an alternative to system **1400** shown in **Figure 14****.** System **1600** may be used to implement method **1500** of **Figure 15****.** System **1600** may be implemented using the lean product manufacturing techniques described with respect to **Figure 2** through **Figure 13****.**

System **1600** may include lean product modeling analysis and simulation system **1602.** Lean product modeling analysis and simulation system **1602** may include non-transitory computer readable storage medium **1604,** which stores plurality of modeling objects **1606.** Plurality of modeling objects **1606** have a plurality of corresponding modeling object properties **1608** and a plurality of corresponding object property data items **1610.**

Plurality of modeling objects **1606** may represent multiple perspectives **1612** of product or application as a service **1614.** Plurality of corresponding modeling object properties **1608** may identifying characteristics of those product modeling objects which are used to configure product simulations. Plurality of corresponding object property data items **1610** may define those characteristics and are reflected in product simulations and analyses. These objects, properties, and data items may be tailored for each lifecycle phase of the product.

Each modeling object may be linked to single integrated product knowledge model **1616.** Single integrated product knowledge model **1616** may define ontologically the production or the application as the service **1614.** Single integrated product knowledge model **1616** may identify a corresponding authoritative source for corresponding modeling objects of plurality of corresponding modeling object properties **1608.**

Lean product modeling analysis and simulation system **1600** may also include at least one processor **1618.** At least one processor **1618** may be configured to execute plurality of disparate tools **1620** for manipulating plurality of modeling objects **1606.** Each of plurality of disparate tools **1620** may include at least one corresponding element **1622** stored in non-transitory computer readable storage medium **1604.** Every corresponding element of plurality of disparate tools **1620** may be linked to at least one corresponding concept in single integrated product knowledge model **1616.** A given corresponding element of a given tool may be linked to a related element in a different tool through single integrated product knowledge model **1616.**

Lean product modeling analysis and simulation system **1602** may also include input system **1624.** Input system **1624** may be configured to receive input to create a design of product or application as the service **1614** using other elements of lean product modeling analysis and simulation system **1602.**

Lean product modeling analysis and simulation system **1602** also may include communication system **1626.** Communication system **1626** may be configured to communicate a command to at least one device **1628** to participate in manufacturing the product, or implementing the application as the service, using the design.

Lean product modeling analysis and simulation system **1602** may be varied. For example, for lean product modeling analysis and simulation system **1602,** at least some of the plurality of disparate tools may be incompatible with each other without use of single integrated product knowledge model **1616.** Additionally, the given tool and the different tool may be included in the at least some of the plurality of disparate tools that are incompatible with each other.

In another illustrative embodiment, lean product modeling analysis and simulation system **1602** may be further configured to perform cross tool engineering data analysis through single integrated product knowledge model **1616.** Thus, the illustrative embodiments are not necessarily limited to a particular example described herein.

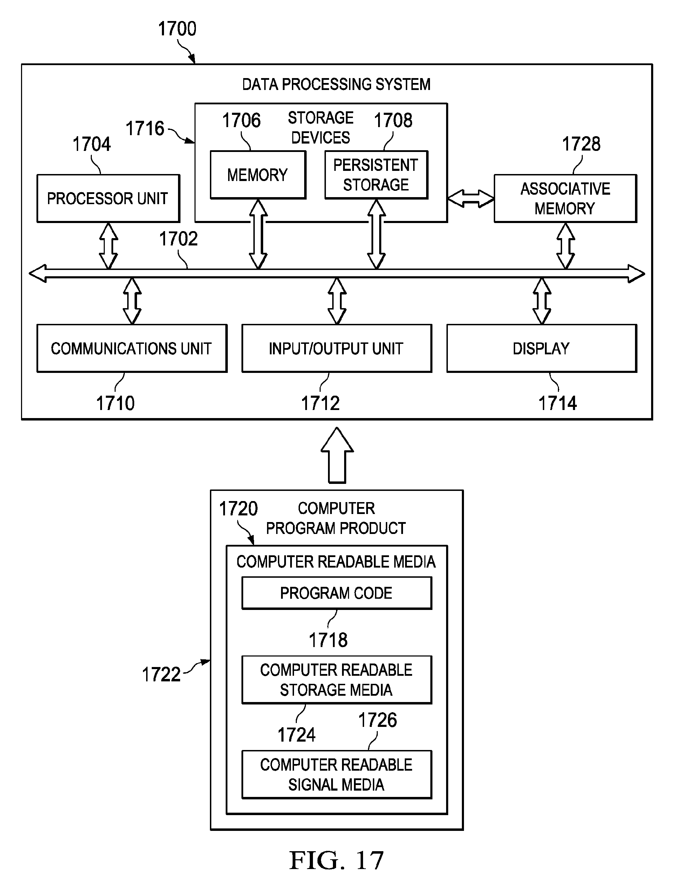

**Figure 17** illustrates a data processing system, in accordance with an illustrative embodiment. Data processing system **1700** in **Figure 17** most typically will be one of many distinct data processing systems used in a distributed collaborative computing context. For example, data processing system **1700** could be any one of the work stations or computers used to implement the various tool suites shown at reference numerals **304, 306, 308, 310, 312** in **Figure 3****,** and elsewhere in the specification. However, data processing system **1700** may be considered an example of any number of data processing systems used to implement the various techniques described herein, or may also be considered itself a number of different processors operating in concert.

Thus, for example, data processing system **1700** in **Figure 17** may be an example of a data processing system that used to implement the illustrative embodiments, such as LPM environment **200** of **Figure 2****,** LPM environment **300** of **Figure 3****,** LPM environment **400** of **Figure 4****,** product knowledge object model **500** of **Figures 5A-5C****,** product knowledge object model **600** of **Figure 6****,** product knowledge object model **700** of **Figure 7****,** product knowledge object model **800** of **Figures 8A-8B****,** product knowledge object model **900** of **Figure** 9, product knowledge object model **1000** of **Figure 10****,** product knowledge object model **1200** of **Figure 13****,** system **1400** of **Figure 14****,** method **1500** of **Figure 15****,** lean product modeling analysis and simulation system **1602** of **Figure 16****,** any other module or system or process disclosed herein. However, such a computer may also only be a part of a larger manufacturing process. Thus, for example, data processing system 1700 may be used in the manufacturing of a physical product or an application as a service, or software, using lean product manufacturing techniques as described above.

In this illustrative example, data processing system **1700** includes communications fabric **1702,** which provides communications between processor unit **1704,** memory **1706,** persistent storage **1708,** communications unit **1710,** input/output (I/O) unit **1712,** and display **1714.** Processor unit **1704** serves to execute instructions for software that may be loaded into memory **1706.** Processor unit **1704** may be a number of processors, a multi-processor core, or some other type of processor, depending on the particular implementation. "A number," as used herein with reference to an item, means one or more items. Further, processor unit **1704** may be implemented using a number of heterogeneous processor systems in which a main processor is present with secondary processors on a single chip. As another illustrative example, processor unit **1704** may be a symmetric multi-processor system containing multiple processors of the same type.

Memory **1706** and persistent storage **1708** are examples of storage devices **1716.** A storage device is any piece of hardware that is capable of storing information, such as, for example, without limitation, data, program code in functional form, and/or other suitable information either on a temporary basis and/or a permanent basis. Storage devices **1716** may also be referred to as computer readable storage devices in these examples. Memory **1706,** in these examples, may be, for example, a random access memory or any other suitable volatile or nonvolatile storage device. Persistent storage **1708** may take various forms, depending on the particular implementation.

For example, persistent storage **1708** may contain one or more components or devices. For example, persistent storage **1708** may be a hard drive, a flash memory, a rewritable optical disk, a rewritable magnetic tape, or some combination of the above. The media used by persistent storage **1708** also may be removable. For example, a removable hard drive may be used for persistent storage **1708.**

Communications unit **1710,** in these examples, provides for communications with other data processing systems or devices. In these examples, communications unit **1710** is a network interface card. Communications unit **1710** may provide communications through the use of either or both physical and wireless communications links.

Input/output (I/O) unit **1712** allows for input and output of data with other devices that may be connected to data processing system **1700.** For example, input/output (I/O) unit **1712** may provide a connection for user input through a keyboard, a mouse, and/or some other suitable input device. Further, input/output (I/O) unit **1712** may send output to a printer. Display **1714** provides a mechanism to display information to a user.

Instructions for the operating system, applications, and/or programs may be located in storage devices **1716,** which are in communication with processor unit **1704** through communications fabric **1702.** In these illustrative examples, the instructions are in a functional form on persistent storage **1708.** These instructions may be loaded into memory **1706** for execution by processor unit **1704.** The processes of the different embodiments may be performed by processor unit **1704** using computer implemented instructions, which may be located in a memory, such as memory **1706.**

These instructions are referred to as program code, computer usable program code, or computer readable program code that may be read and executed by a processor in processor unit **1704.** The program code in the different embodiments may be embodied on different physical or computer readable storage media, such as memory **1706** or persistent storage **1708.**

Program code **1718** is located in a functional form on computer readable media **1720** that is selectively removable and may be loaded onto or transferred to data processing system **1700** for execution by processor unit **1704.** Program code **1718** and computer readable media **1720** form computer program product **1722** in these examples. In one example, computer readable media **1720** may be computer readable storage media **1724** or computer readable signal media **1726.** Computer readable storage media **1724** may include, for example, an optical or magnetic disk that is inserted or placed into a drive or other device that is part of persistent storage **1708** for transfer onto a storage device, such as a hard drive, that is part of persistent storage **1708.** Computer readable storage media **1724** also may take the form of a persistent storage, such as a hard drive, a thumb drive, or a flash memory, that is connected to data processing system **1700.** In some instances, computer readable storage media **1724** may not be removable from data processing system **1700.**

Alternatively, program code **1718** may be transferred to data processing system **1700** using computer readable signal media **1726.** Computer readable signal media **1726** may be, for example, a propagated data signal containing program code **1718.** For example, computer readable signal media **1726** may be an electromagnetic signal, an optical signal, and/or any other suitable type of signal. These signals may be transmitted over communications links, such as wireless communications links, optical fiber cable, coaxial cable, a wire, and/or any other suitable type of communications link. In other words, the communications link and/or the connection may be physical or wireless in the illustrative examples.

In some illustrative embodiments, program code **1718** may be downloaded over a network to persistent storage **1708** from another device or data processing system through computer readable signal media **1726** for use within data processing system **1700.** For instance, program code stored in a computer readable storage medium in a server data processing system may be downloaded over a network from the server to data processing system **1700.** The data processing system providing program code **1718** may be a server computer, a client computer, or some other device capable of storing and transmitting program code **1718.**

The different components illustrated for data processing system **1700** are not meant to provide architectural limitations to the manner in which different embodiments may be implemented. The different illustrative embodiments may be implemented in a data processing system including components in addition to or in place of those illustrated for data processing system **1700.** Other components shown in **Figure 17** can be varied from the illustrative examples shown. The different embodiments may be implemented using any hardware device or system capable of running program code. As one example, the data processing system may include organic components integrated with inorganic components and/or may be comprised entirely of organic components excluding a human being. For example, a storage device may be comprised of an organic semiconductor.

In another illustrative example, processor unit **1704** may take the form of a hardware unit that has circuits that are manufactured or configured for a particular use. This type of hardware may perform operations without needing program code to be loaded into a memory from a storage device to be configured to perform the operations.

For example, when processor unit **1704** takes the form of a hardware unit, processor unit **1704** may be a circuit system, an application specific integrated circuit (ASIC), a programmable logic device, or some other suitable type of hardware configured to perform a number of operations. With a programmable logic device, the device is configured to perform the number of operations. The device may be reconfigured at a later time or may be permanently configured to perform the number of operations. Examples of programmable logic devices include, for example, a programmable logic array, programmable array logic, a field programmable logic array, a field programmable gate array, and other suitable hardware devices. With this type of implementation, program code **1718** may be omitted because the processes for the different embodiments are implemented in a hardware unit.

In still another illustrative example, processor unit **1704** may be implemented using a combination of processors found in computers and hardware units. Processor unit **1704** may have a number of hardware units and a number of processors that are configured to run program code **1718.** With this depicted example, some of the processes may be implemented in the number of hardware units, while other processes may be implemented in the number of processors.

As another example, a storage device in data processing system **1700** is any hardware apparatus that may store data. Memory **1706,** persistent storage **1708,** and computer readable media **1720** are examples of storage devices in a tangible form.

In another example, a bus system may be used to implement communications fabric **1702** and may be comprised of one or more buses, such as a system bus or an input/output bus. Of course, the bus system may be implemented using any suitable type of architecture that provides for a transfer of data between different components or devices attached to the bus system. Additionally, a communications unit may include one or more devices used to transmit and receive data, such as a modem or a network adapter. Further, a memory may be, for example, memory **1706,** or a cache, such as found in an interface and memory controller hub that may be present in communications fabric **1702.**

Data processing system **1700** may also include associative memory **1728.** Associative memory **1728** may be in communication with communications fabric **1702.** Associative memory **1728** may also be in communication with, or in some illustrative embodiments, be considered part of storage devices **1716.** While one associative memory **1728** is shown, additional associative memories may be present.

As used herein, the term "associative memory" refers to a plurality of data and a plurality of associations among the plurality of data. The plurality of data and the plurality of associations may be stored in a non-transitory computer readable storage medium. The plurality of data may be collected into associated groups. The associative memory may be configured to be queried based on at least indirect relationships among the plurality of data in addition to direct correlations among the plurality of data. Thus, an associative memory may be configured to be queried based solely on direct relationships, based solely on at least indirect relationships, as well as based on combinations of direct and at least indirect relationships. An associative memory may be a content addressable memory.

Thus, an associative memory may be characterized as a plurality of data and a plurality of associations among the plurality of data. The plurality of data may be collected into associated groups. Further, the associative memory may be configured to be queried based on at least one relationship, selected from a group that includes direct and at least indirect relationships, or from among the plurality of data in addition to direct correlations among the plurality of data. An associative memory may also take the form of software. Thus, an associative memory also may be considered a process by which information is collected into associated groups in the interest of gaining new insight based on relationships rather than direct correlation. An associative memory may also take the form of hardware, such as specialized processors or a field programmable gate array.

The different illustrative embodiments can take the form of an entirely hardware embodiment, an entirely software embodiment, or an embodiment containing both hardware and software elements. Some embodiments are implemented in software, which includes but is not limited to forms such as, for example, firmware, resident software, and microcode.

Furthermore, the different embodiments can take the form of a computer program product accessible from a computer usable or computer readable medium providing program code for use by or in connection with a computer or any device or system that executes instructions. For the purposes of this disclosure, a computer usable or computer readable medium can generally be any tangible apparatus that can contain, store, communicate, propagate, or transport the program for use by or in connection with the instruction execution system, apparatus, or device.

The computer usable or computer readable medium can be, for example, without limitation an electronic, magnetic, optical, electromagnetic, infrared, or semiconductor system, or a propagation medium. Non-limiting examples of a computer readable medium include a semiconductor or solid state memory, magnetic tape, a removable computer diskette, a random access memory (RAM), a read-only memory (ROM), a rigid magnetic disk, and an optical disk. Optical disks may include compact disk - read only memory (CD-ROM), compact disk - read/write (CD-R/W), and DVD.

Further, a computer usable or computer readable medium may contain or store a computer readable or computer usable program code such that when the computer readable or computer usable program code is executed on a computer, the execution of this computer readable or computer usable program code causes the computer to transmit another computer readable or computer usable program code over a communications link. This communications link may use a medium that is, for example without limitation, physical or wireless.

A data processing system suitable for storing and/or executing computer readable or computer usable program code will include one or more processors coupled directly or indirectly to memory elements through a communications fabric, such as a system bus. The memory elements may include local memory employed during actual execution of the program code, bulk storage, and cache memories which provide temporary storage of at least some computer readable or computer usable program code to reduce the number of times code may be retrieved from bulk storage during execution of the code.

Input/output or I/O devices can be coupled to the system either directly or through intervening I/O controllers. These devices may include, for example, without limitation, keyboards, touch screen displays, and pointing devices. Different communications adapters may also be coupled to the system to enable the data processing system to become coupled to other data processing systems or remote printers or storage devices through intervening private or public networks. Non-limiting examples of modems and network adapters are just a few of the currently available types of communications adapters.

The disclosure comprises the following clauses:
Clause 1. A system (1400,1600) for manufacturing a product or providing an application as a service, comprising:
   a lean product or service modeling analysis and simulation system (1402,1602), comprising:
      at least one non-transitory computer readable storage medium (1404,1604) storing a plurality of modeling objects (1406,1606) representing multiple perspectives (1408,1612) of the product, a plurality of corresponding modeling object properties (1410,1608) identifying characteristics of those product modeling objects which are used to configure product simulations, and a plurality of corresponding modeling object property data items (1412,1610) that define those characteristics and are reflected in product simulations and analyses, wherein the modeling objects, the corresponding modeling object properties (1410,1608), and at least some of the plurality of corresponding modeling property data items (1412,1610) are tailored for each lifecycle phase of the product, wherein at least some product modeling objects are linked in an integrated product knowledge model (1414,1616) that reflects ontological characteristics of the product or the application as a service and a corresponding operational environment, and wherein the product knowledge model(1414,1616) defines an authoritative source for any specific corresponding modeling object within the plurality of corresponding modeling objects (1406,1606);
      at least one processor(1418,1618) configured to execute a plurality of disparate tools (1420,1620) for manipulating the plurality of modeling objects, each of the plurality of disparate tools (1420,1620) comprising at least one corresponding element (1422,1622) stored in the non-transitory computer readable storage medium (1404,1604), wherein at least some corresponding elements (1422,1622) of the plurality of disparate tools (1420,1620) are linked to at least one corresponding concept in the integrated product knowledge model (1414,1616), and wherein at least some given corresponding elements (1422,1622) of a given tool are linked to a related element in a different tool through the integrated product knowledge model (1414,1616); and
      at least one device (1424,1628) for use in manufacturing the product or implementing the application as the service based on a product design created by the lean product or service modeling analysis and simulation system (1402,1602).
Clause 2. The system (1400, 1600) of clause 1, wherein at least some of the plurality of disparate tools (1420,1620) are incompatible with each other without use of the integrated product knowledge model (1414,1616).
Clause 3. The system (1400, 1600) of clause 2, wherein the given tool and the different tool are incompatible with each other.
Clause 4. The system (1400, 1600) of any preceding clause, wherein the at least one processor (1418,1618) is configured to perform cross tool engineering data analysis through the integrated product knowledge model (1414,1616).
Clause 5. The system (1400, 1600) of any preceding clause, wherein the plurality of modeling objects (1406,1606) are discoverable by at least one product knowledge model query that traverses a hyperlink to a modeling object stored on a different non-transitory computer readable storage medium (1404,1604).
Clause 6. The system (1400, 1600) of any preceding clause, wherein the plurality of modeling objects (1406,1606) are configured to be traced and analyzed throughout a lifecycle of a program through connections provided and maintained within the integrated product knowledge model (1414,1618).
Clause 7. The system (1400, 1600) of clause 6, wherein the lifecycle phase is selected from the group consisting of exploratory, conceptual, prototyping, developmental, manufacturing, operation, support, derivative product creation, and product disposition.
Clause 8. The system (1400, 1600) of any preceding clause, wherein a change to a given modeling object in the plurality of modeling objects (1406,1606) will set a flag to validate every other related modeling object in the plurality of modeling objects (1406,1606) linked to the given modeling object via the integrated product knowledge model (1414,1616).
Clause 9. The system (1400, 1600) of any preceding clause, wherein the integrated product knowledge model (1414,1616) further includes data describing conditions of use for the product, the data including preconditions and constraints.
Clause 10. A method (1500) for manufacturing a product or implementing an application as a service, using a lean product modeling analysis and simulation system (1402,1602), the method comprising:
   providing input to at least one non-transitory computer readable storage medium (1404,1604) via manipulating at least one physical input device (1502), the input comprising:
      a plurality of modeling objects (1406,1606) having a plurality of corresponding modeling object properties (1410,1608) and a plurality of corresponding object property data items (1412,1610), the plurality of modeling objects (1406,1606) representing multiple perspectives (1408,1612) of the product or the application as the service, the plurality of corresponding modeling object properties (1410,1608) identifying characteristics of those product modeling objects which are used to configure product simulations, and wherein the plurality of modeling objects (1406,1606), at least some of the plurality of corresponding modeling object properties (1410,1608), and the plurality of corresponding object property data items (1412,1610) are tailored for each lifecycle phase of the product or the application as the service; and
      an integrated product knowledge model (1414,1616) that ontologically defines the product or the application as the service, wherein at least some of the plurality of modeling objects (1406,1606) are linked to the integrated product knowledge model (1414,1616), and wherein the integrated product knowledge model (1414,1616) identifies a corresponding authoritative source for corresponding modeling objects of the plurality of modeling objects (1406,1606); and
   manufacturing the product or implementing the application as the service using at least one device based on a product design produced by the lean product modeling analysis and simulation system (1402,1602).
Clause 11. The method of clause 10, wherein a plurality of disparate tools (1420,1620) for manipulating the plurality of modeling objects (1406,1606) are stored in the at least one non-transitory computer readable storage medium (1404,1604), each of the plurality of disparate tools (1420,1620) comprising at least one corresponding element (1422,1622), and wherein the method comprises:
   linking, using at least one processor (1418,1618) in communication with the non-transitory computer readable storage medium (1404,1604), corresponding elements(1422,1622) of the plurality of disparate tools (1420,1620) to at least one corresponding concept in the integrated product knowledge model (1414,1616).
Clause 12. The method of clause 11 further comprising:
   linking, using at least one processor (1418,1618), a given corresponding element(1422,1622) of a given tool to a related element in a different tool through the integrated product knowledge model (1414,1616).
Clause 13. The method of clause 12 further comprising:
   creating, and storing on at least one non-transitory computer readable storage medium (1404,1604), a product design using the plurality of disparate tools (1420,1620), wherein using the plurality of disparate tools (1420,1620)comprises at least one user manipulating at least one physical user input device.
Clause 14. The method of clause 12 or 13, wherein at least some of the plurality of disparate tools (1420,1620) are incompatible with each other without use of the integrated product knowledge model (1414,1616).
Clause 15. The method of any of clauses 12 to 14, further comprising:
   performing, by the at least one processor (1418,1618), cross tool engineering data analysis through the integrated product knowledge model (1414,1616).
Clause 16. The method of any of clauses 10 to 15, further comprising:
   discovering the plurality of modeling objects (1406,1606) by using at least one product knowledge model(1414,1616) query that may traverse a hyperlink to a modeling object stored on a different non-transitory computer readable storage medium (1404,1604).
Clause 17. The method of any of clauses 10 to 16, further comprising:
   in response to changes on a given modeling object in the plurality of modeling objects (1406,1606), validating every related modeling object in the plurality of modeling objects (1406,1606) that are linked to the given modeling object, wherein validating is performed via the integrated product knowledge model (1414,1616).
Clause 18. A system (1400, 1600) comprising:
   a lean product modeling analysis and simulation system (1402,1602), comprising:
      at least one non-transitory computer readable storage medium (1404,1604) storing a plurality of modeling objects (1406,1606) having a plurality of corresponding modeling object properties (1410,1608) and a plurality of corresponding object property data items (1412,1610), the plurality of modeling objects (1406,1606) representing multiple perspectives (1408,1612) of a product or an application as a service the plurality of corresponding modeling object properties (1410,1608) identifying characteristics of those product modeling objects which are used to configure product simulations, the plurality of corresponding object property data items (1412,1610) that define those characteristics and are reflected in product simulations and analyses, these objects, properties, and data items being tailored for each lifecycle phase of the product, wherein at least some modeling objects are linked to an integrated product knowledge model (1414,1616) that ontologically defines the product or the application as the service and identifies a corresponding authoritative source for corresponding modeling objects of the plurality of modeling objects (1406,1606);
      at least one processor (1418,1618) configured to execute a plurality of disparate tools (1420,1620) for manipulating the plurality of modeling objects (1406,1606), at least some of the plurality of disparate tools (1420,1620) comprising at least one corresponding element (1422,1622) stored in the at least one non-transitory computer readable storage medium (1404,1604), wherein at least some corresponding elements(1422,1622) of the plurality of disparate tools (1420,1620) are linked to at least one corresponding concept in the integrated product knowledge model (1414,1616), and wherein at least one given corresponding element (1422,1622) of a given tool is linked to a related element in a different tool through the integrated product knowledge model (1414,1616); and
      at least one input system (1624) configured to receive input to create a design of the product or the application as the service using the lean product modeling analysis and simulation system (1402,1602);
      at least one communication system (1626) configured to communicate at least one command to at least one device (1424,1628) to participate in manufacturing the product, or implementing the application as the service, using the design.
Clause 19. The system (1400,1600) of clause 18, wherein:
   at least some of the plurality of disparate tools (1420,1620) are incompatible with each other without use of the integrated product knowledge model (1414,1616); and
   the given tool and the different tool are included in the at least some of the plurality of disparate tools (1420,1620) that are incompatible with each other.
Clause 20. The system (1400,1600) of clause 18 or 19, wherein the lean product modeling analysis and simulation system (1402,1602) is further configured to perform cross tool engineering data analysis through the integrated product knowledge model (1414,1616).

The description of the different illustrative embodiments has been presented for purposes of illustration and description, and is not intended to be exhaustive or limited to the embodiments in the form disclosed. Many modifications and variations will be apparent to those of ordinary skill in the art. Further, different illustrative embodiments may provide different features as compared to other illustrative embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A system (1400,1600) for manufacturing a product or providing an application as a service, comprising:
a lean product or service modeling analysis and simulation system (1402,1602), comprising:
at least one non-transitory computer readable storage medium (1404,1604) storing a plurality of modeling objects (1406,1606) representing multiple perspectives (1408,1612) of the product, a plurality of corresponding modeling object properties (1410,1608) identifying characteristics of those product modeling objects which are used to configure product simulations, and a plurality of corresponding modeling object property data items (1412,1610) that define those characteristics and are reflected in product simulations and analyses, wherein the modeling objects, the corresponding modeling object properties (1410,1608), and at least some of the plurality of corresponding modeling property data items (1412,1610) are tailored for each lifecycle phase of the product, wherein at least some product modeling objects are linked in an integrated product knowledge model (1414,1616) that reflects ontological characteristics of the product or the application as a service and a corresponding operational environment, and wherein the product knowledge model(1414,1616) defines an authoritative source for any specific corresponding modeling object within the plurality of corresponding modeling objects (1406,1606);
at least one processor(1418,1618) configured to execute a plurality of disparate tools (1420,1620) for manipulating the plurality of modeling objects, each of the plurality of disparate tools (1420,1620) comprising at least one corresponding element (1422,1622) stored in the non-transitory computer readable storage medium (1404,1604), wherein at least some corresponding elements (1422,1622) of the plurality of disparate tools (1420,1620) are linked to at least one corresponding concept in the integrated product knowledge model (1414,1616), and wherein at least some given corresponding elements (1422,1622) of a given tool are linked to a related element in a different tool through the integrated product knowledge model (1414,1616); and
at least one device (1424,1628) for use in manufacturing the product or implementing the application as the service based on a product design created by the lean product or service modeling analysis and simulation system (1402,1602).

2. The system (1400, 1600) of claim 1, wherein at least some of the plurality of disparate tools (1420,1620) are incompatible with each other without use of the integrated product knowledge model (1414,1616).

3. The system (1400, 1600) of claim 1 or 2, wherein the at least one processor (1418,1618) is configured to perform cross tool engineering data analysis through the integrated product knowledge model (1414,1616).

4. The system (1400, 1600) of any preceding claim, wherein the plurality of modeling objects (1406,1606) are discoverable by at least one product knowledge model query that traverses a hyperlink to a modeling object stored on a different non-transitory computer readable storage medium (1404,1604).

5. The system (1400, 1600) of any preceding claim, wherein the plurality of modeling objects (1406,1606) are configured to be traced and analyzed throughout a lifecycle of a program through connections provided and maintained within the integrated product knowledge model (1414,1618).

6. The system (1400, 1600) of claim 5, wherein the lifecycle phase is selected from the group consisting of exploratory, conceptual, prototyping, developmental, manufacturing, operation, support, derivative product creation, and product disposition.

7. The system (1400, 1600) of any preceding claim, wherein a change to a given modeling object in the plurality of modeling objects (1406,1606) will set a flag to validate every other related modeling object in the plurality of modeling objects (1406,1606) linked to the given modeling object via the integrated product knowledge model (1414,1616); and wherein the integrated product knowledge model (1414,1616) further includes data describing conditions of use for the product, the data including preconditions and constraints.

8. A method (1500) for manufacturing a product or implementing an application as a service, using a lean product modeling analysis and simulation system (1402,1602), the method comprising:
providing input to at least one non-transitory computer readable storage medium (1404,1604) via manipulating at least one physical input device (1502), the input comprising:
a plurality of modeling objects (1406,1606) having a plurality of corresponding modeling object properties (1410,1608) and a plurality of corresponding object property data items (1412,1610), the plurality of modeling objects (1406,1606) representing multiple perspectives (1408,1612) of the product or the application as the service, the plurality of corresponding modeling object properties (1410,1608) identifying characteristics of those product modeling objects which are used to configure product simulations, and wherein the plurality of modeling objects (1406,1606), at least some of the plurality of corresponding modeling object properties (1410,1608), and the plurality of corresponding object property data items (1412,1610) are tailored for each lifecycle phase of the product or the application as the service; and
an integrated product knowledge model (1414,1616) that ontologically defines the product or the application as the service, wherein at least some of the plurality of modeling objects (1406,1606) are linked to the integrated product knowledge model (1414,1616), and wherein the integrated product knowledge model (1414,1616) identifies a corresponding authoritative source for corresponding modeling objects of the plurality of modeling objects (1406,1606); and
manufacturing the product or implementing the application as the service using at least one device based on a product design produced by the lean product modeling analysis and simulation system (1402,1602).

9. The method of claim 8, wherein a plurality of disparate tools (1420,1620) for manipulating the plurality of modeling objects (1406,1606) are stored in the at least one non-transitory computer readable storage medium (1404,1604), each of the plurality of disparate tools (1420,1620) comprising at least one corresponding element (1422,1622), and wherein the method comprises:
linking, using at least one processor (1418,1618) in communication with the non-transitory computer readable storage medium (1404,1604), corresponding elements(1422,1622) of the plurality of disparate tools (1420,1620) to at least one corresponding concept in the integrated product knowledge model (1414,1616).

10. The method of claim 9, further comprising:
linking, using at least one processor (1418,1618), a given corresponding element(1422,1622) of a given tool to a related element in a different tool through the integrated product knowledge model (1414,1616).

11. The method of claim 10, further comprising:
creating, and storing on at least one non-transitory computer readable storage medium (1404,1604), a product design using the plurality of disparate tools (1420,1620), wherein using the plurality of disparate tools (1420,1620)comprises at least one user manipulating at least one physical user input device; and wherein at least some of the plurality of disparate tools (1420,1620) are incompatible with each other without use of the integrated product knowledge model (1414,1616).

12. The method of claim 11, further comprising:
performing, by the at least one processor (1418,1618), cross tool engineering data analysis through the integrated product knowledge model (1414,1616).

13. The method of any of claims 9 to 12, further comprising:
discovering the plurality of modeling objects (1406,1606) by using at least one product knowledge model(1414,1616) query that may traverse a hyperlink to a modeling object stored on a different non-transitory computer readable storage medium (1404,1604).

14. The method of any of claims 9 to 13, further comprising:
in response to changes on a given modeling object in the plurality of modeling objects (1406,1606), validating every related modeling object in the plurality of modeling objects (1406,1606) that are linked to the given modeling object, wherein validating is performed via the integrated product knowledge model (1414,1616).
